(19) Europäisches Patentamt
European Patent Office
Office européen des brevets

(11) **EP 4 669 063 A1**

(12) **EUROPEAN PATENT APPLICATION**

(43) Date of publication:
**24.12.2025 Bulletin 2025/52**

(21) Application number: **25182984.2**

(22) Date of filing: **16.06.2025**

(51) International Patent Classification (IPC):
***H10H 20/81*** *(2025.01)* ***H10H 20/84*** *(2025.01)*

(52) Cooperative Patent Classification (CPC):
**H10H 20/8215; H10H 20/84;** H10H 20/825

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **17.06.2024 KR 20240078018**

(71) Applicant: **Samsung Display Co., Ltd.
Yongin-si, Gyeonggi-do 17113 (KR)**

(72) Inventors:
• **CHO, Hyun Min**
 **Yongin-si (KR)**
• **KIM, In Hyuk**
 **Yongin-si (KR)**
• **SIM, Young Chul**
 **Yongin-si (KR)**
• **JIN, Tae Ha**
 **Yongin-si (KR)**
• **CHOI, Hyeong Su**
 **Yongin-si (KR)**

(74) Representative: **Marks & Clerk LLP
15 Fetter Lane
London EC4A 1BW (GB)**

(54) **LIGHT EMITTING ELEMENT AND DISPLAY DEVICE INCLUDING THE SAME**

(57)     A light emitting element includes a first semiconductor layer doped with an n-type dopant, a second semiconductor layer disposed on the first semiconductor layer and doped with a p-type dopant, an active layer between the first semiconductor layer and the second semiconductor layer, an electrode layer disposed on the second semiconductor layer, and an insulating film surrounding an outer surface of at least the active layer. A diameter of the first semiconductor layer is in a range of about 0.5 μm to about 10 μm, and the insulating film includes a first layer surrounding the first semiconductor layer, the second semiconductor layer, and the active layer and a second layer disposed on the first layer and including aluminium nitride (AlN).

**FIG. 2**

EP 4 669 063 A1

**Description**

BACKGROUND

1. Technical Field

Embodiments relate to a light emitting element and a display device including the same.

2. Description of the Related Art

Display devices are becoming increasingly important with the development of multimedia. Accordingly, various types of display devices such as organic light emitting displays (OLEDs) and liquid crystal displays (LCDs) are being used.
As a device that displays an image of a display device, there is a self-luminous display device including a light emitting element. The self-luminous display device may be an organic light emitting display using an organic material as a light emitting material as a light emitting element or an inorganic light emitting display using an inorganic material as a light emitting material.

SUMMARY

Embodiments provide a light emitting element having reduced afterimages when emitting light and a display device including the light emitting element.
However, embodiments are not limited to those set forth herein. The above and other embodiments will be apparent to one of ordinary skill in the art to which the disclosure pertains by referencing the detailed description of the disclosure given below.
According to an embodiment, a light emitting element includes a first semiconductor layer doped with an n-type dopant, a second semiconductor layer disposed on the first semiconductor layer and doped with a p-type dopant, an active layer between the first semiconductor layer and the second semiconductor layer, an electrode layer disposed on the second semiconductor layer, and an insulating film surrounding an outer surface of at least the active layer. A diameter of the first semiconductor layer is in a range of about 0.5 $\mu$m to about 10 $\mu$m, and the insulating film includes a first layer surrounding the first semiconductor layer, the second semiconductor layer, and the active layer and a second layer disposed on the first layer and comprising aluminium nitride (AlN).
The diameter of the first semiconductor layer may be in a range of about 0.5 $\mu$m to about 5 $\mu$m, and the active layer may emit light having a main peak wavelength in a range of about 370 nm to about 460 nm.
The insulating film may further include a third layer disposed on the second layer and a fourth layer disposed on the third layer, and each of the third layer and the fourth layer may include at least one of silicon oxide ($SiO_x$), silicon nitride ($SiN_x$), silicon oxynitride ($SiO_xN_y$), aluminium nitride ($AlN_x$), aluminium oxide ($AlO_x$), zirconium oxide ($ZrO_x$), hafnium oxide ($HfO_x$), and titanium oxide ($TiO_x$). x may be a first rational number greater than 0, and y may be a second rational number greater than 0.
The third layer may include silicon oxide ($SiO_x$) and directly contact the second layer.
A thickness of each of the third layer and the fourth layer of the insulating film may be greater than a thickness of each of the first layer and the second layer, and the thickness of the fourth layer may be greater than the thickness of the third layer.
The thickness of each of the first layer and the second layer may be in a range of about 1 nm to about 3 nm.
The thickness of the third layer may be greater than or equal to about 10 nm, and the thickness of the fourth layer may be in a range of about 40 nm to about 100 nm.
The first layer may include a first sub-layer, a second sub-layer surrounding the first sub-layer, and a third sub-layer surrounding the second sub-layer. The first sub-layer and the third sub-layer may include a same material. A thickness of the first sub-layer may be greater than a thickness of each of the second sub-layer and the third sub-layer.
The first sub-layer and the third sub-layer may include zirconium oxide ($ZrO_2$), and the second sub-layer may include aluminium oxide ($Al_2O_3$) or hafnium oxide ($HfO_2$).
The thickness of the first sub-layer may be about 2 nm, and the thickness of each of the second sub-layer and the third sub-layer may be about 1 nm.
A reference luminance may be a luminance of light emitted in case that a first driving current is supplied, in case that the first driving current is supplied after a second driving current is supplied, a restoration time taken for the luminance of light emitted to reach a restored luminance may be less than or equal to about 10 seconds. The restored luminance may satisfy Equation 1 below.

[Equation 1]

$$0.99 \times \text{reference luminance} < \text{restored luminance} < 1.01 \times \text{reference luminance}$$

An intensity of the first driving current and an intensity of the second driving current may be different from each other.

The restoration time may be less than or equal to about 1 second.

The first driving current may be in a range of about 0.5 A/cm$^2$ to about 5 A/cm$^2$.

The second driving current may be in a range of about 0 A/cm$^2$ to about 0.5 A/cm$^2$.

The second driving current may be greater than or equal to about 10 A/cm$^2$.

According to an embodiment, a display device includes a first electrode and a second electrode spaced apart from each other on a substrate, and a light emitting element electrically connected to each of the first electrode and the second electrode and extending in a direction. The light emitting element includes a first semiconductor layer doped with an n-type dopant, a second semiconductor layer disposed on the first semiconductor layer and doped with a p-type dopant, an active layer between the first semiconductor layer and the second semiconductor layer, an electrode layer disposed on the second semiconductor layer, and an insulating film surrounding an outer surface of at least the active layer. A diameter of the first semiconductor layer is in a range of about 0.5 μm to about 10 μm, and the insulating film includes a first layer surrounding the first semiconductor layer, the second semiconductor layer, and the active layer and a second layer disposed on the first layer and comprising aluminium nitride (AlN).

The insulating film of the light emitting element may further include a third layer disposed on the second layer and a fourth layer disposed on the third layer, and each of the third layer and the fourth layer may include at least one of silicon oxide (SiO$_x$), silicon nitride (SiN$_x$), silicon oxynitride (SiO$_x$N$_y$), aluminium nitride (AlN$_x$), aluminium oxide (AlO$_x$), zirconium oxide (ZrO$_x$), hafnium oxide (HfO$_x$), and titanium oxide (TiO$_x$). x may be a first rational number greater than 0, and y may be a second rational number greater than 0.

The third layer of the light emitting element may include silicon oxide (SiO$_x$) and directly contact the second layer.

A thickness of each of the third layer and the fourth layer of the insulating film of the light emitting element may be greater than thicknesses of the first layer and the second layer, and the thickness of the fourth layer may be greater than the thickness of the third layer.

A reference luminance may be a luminance of light emitted in case that a first driving current is supplied, and in case that the first driving current is supplied after a second driving current is supplied, a time taken for the luminance of light emitted to reach a restored luminance may be less than or equal to about 10 seconds. The restored luminance may satisfy Equation 1 below.

[Equation 1]

$$0.99 \times \text{reference luminance} < \text{restored luminance} < 1.01 \times \text{reference luminance}$$

An intensity of the first driving current and an intensity of the second driving current may be different from each other.

According to an embodiment of the disclosure, an electronic device includes a display device including a light emitting element disposed on a substrate. The light emitting element includes a first semiconductor layer doped with an n-type dopant, a second semiconductor layer disposed on the first semiconductor layer and doped with a p-type dopant, an active layer between the first semiconductor layer and the second semiconductor layer, an electrode layer disposed on the second semiconductor layer, and an insulating film surrounding an outer surface of at least the active layer. A diameter of the first semiconductor layer is in a range of about 0.5 μm to about 10 μm, and the insulating film includes a first layer surrounding the first semiconductor layer, the second semiconductor layer, and the active layer and a second layer disposed on the first layer and comprising aluminium nitride (AlN).

The electronic device may be at least one of a smart watch, a mobile phone, a smartphone, a portable computer, a tablet personal computer (PC), a watch phone, an automotive display, a smart glass, a portable multimedia player (PMP), a navigation system, an ultra mobile computer (UMPC), a head mounted display (HMD) device, a virtual reality (VR) device, a mixed reality (MR) device, and an augmented reality (AR) device.

At least some of the above and other features of the invention are set out in the claims.

According to an embodiment, a light emitting element may alleviate an afterimage problem that may occur in a small diameter by controlling the characteristics of an insulating film surrounding semiconductor layers and the characteristics of an active layer.

A display device may reduce a response delay due to a driving signal by including a light emitting element.

BRIEF DESCRIPTION OF THE DRAWINGS

The accompanying drawings, which are included to provide a further understanding of the disclosure, illustrate embodiments in which:

FIG. 1 is a schematic perspective view of a light emitting element according to an embodiment;
FIG. 2 is a schematic cross-sectional view of the light emitting element of FIG. 1;
FIG. 3 is a schematic diagram illustrating an afterimage phenomenon following light emission of the light emitting element according to the embodiment;
FIG. 4 is a graph illustrating a current signal transmitted to the light emitting element according to the embodiment during black stress evaluation of the light emitting element;
FIG. 5 is a schematic graph illustrating the luminance change rate of light emitted from the light emitting element over time in an experiment conducted in FIG. 4;
FIG. 6 is an enlarged view of a luminance change rate portion during a restoration time in the graph of FIG. 5;
FIG. 7 is a graph illustrating a current signal transmitted to the light emitting element according to the embodiment during white stress evaluation of the light emitting element;
FIG. 8 is a schematic graph illustrating the luminance change rate of light emitted from the light emitting element over time in an experiment conducted in FIG. 7;
FIG. 9 is an enlarged view of a luminance change rate portion during the restoration time in the graph of FIG. 8;
FIGS. 10 and 11 are graphs illustrating the restoration time of a conventional light emitting element;
FIG. 12 is a flowchart illustrating a method of manufacturing a light emitting element according to an embodiment;
FIGS. 13 through 25 are schematic cross-sectional views sequentially illustrating a process of manufacturing light emitting elements according to an embodiment;
FIG. 26 is a schematic cross-sectional view of a light emitting element according to an embodiment;
FIG. 27 is a schematic cross-sectional view of a display device according to an embodiment;
FIGS. 28 and 29 are schematic cross-sectional views of display devices according to embodiments; and
FIGS. 30 through 35 are schematic views of electronic devices including a display device according to an embodiment.

DETAILED DESCRIPTION OF THE EMBODIMENTS

The embodiments will now be described more fully hereinafter with reference to the accompanying drawings. The embodiments may, however, be provided in different forms and should not be construed as limiting. The same reference numbers indicate the same components throughout the disclosure. In the accompanying figures, the thickness of layers and regions may be exaggerated for clarity.
Some of the parts which are not associated with the description may not be provided in order to describe embodiments of the disclosure.
It will also be understood that when a layer is referred to as being "on" another layer or substrate, it can be directly on another layer or substrate, or intervening layers may also be present. In contrast, when an element is referred to as being "directly on" another element, there may be no intervening elements present.
Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art. The expression "not overlap" may include meaning such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.
The spatially relative terms "below," "beneath," "lower," "above," "upper," or the like, may be used herein for ease of description to describe the relations between one element or component and another element or component as illustrated in the drawings. It will be understood that the spatially relative terms are intended to encompass different orientations of the device in use or operation, in addition to the orientation depicted in the drawings. For example, in the case where a device illustrated in the drawing is turned over, the device positioned "below" or "beneath" another device may be placed "above" another device. Accordingly, the illustrative term "below" may include both the lower and upper positions. The device may also be oriented in other directions and thus the spatially relative terms may be interpreted differently depending on the orientations.

When an element is referred to as being "connected" or "coupled" to another element, the element may be "directly connected" or "directly coupled" to another element, or "electrically connected" or "electrically coupled" to another element with one or more intervening elements interposed therebetween. It will be further understood that when the terms "comprises," "comprising," "has," "have," "having," "includes" and/or "including" are used, they may specify the presence of stated features, integers, steps, operations, elements and/or components, but do not preclude the presence or addition of other features, integers, steps, operations, elements, components, and/or any combination thereof.

It will be understood that, although the terms "first," "second," "third," or the like may be used herein to describe various elements, these elements should not be limited by these terms. These terms are used to distinguish one element from another element or for the convenience of description and explanation thereof. For example, when "a first element" is discussed in the description, it may be termed "a second element" or "a third element," and "a second element" and "a third element" may be termed in a similar manner without departing from the teachings herein.

The terms "about" or "approximately" as used herein is inclusive of the stated value and means within an acceptable range of deviation for the particular value as determined by one of ordinary skill in the art, considering the measurement in question and the error associated with measurement of the particular quantity (for example, the limitations of the measurement system). For example, "about" may mean within one or more standard deviations, or within about $\pm$ 30 %, 20 %, 10 %, 5 % of the stated value.

In the description, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or." In the description, the phrase "at least one of" is intended to include the meaning of "at least one selected from the group of" for the purpose of its meaning and interpretation. For example, "at least one of A and B" may be understood to mean "A, B, or A and B."

Unless otherwise defined or implied, all terms used herein (including technical and scientific terms) have the same meaning as commonly understood by those skilled in the art to which this disclosure pertains. It will be further understood that terms, such as those defined in commonly used dictionaries, should be interpreted as having a meaning that is consistent with their meaning in the context of the relevant art and will not be interpreted in an ideal or excessively formal sense unless clearly defined in the description.

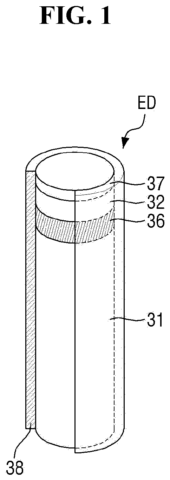

FIG. 1 is a schematic perspective view of a light emitting element ED according to an embodiment.

Referring to FIG. 1, the light emitting element ED may be a light emitting diode. For example, the light emitting element ED may be an inorganic light emitting diode having a size of nanometers to micrometers and made of an inorganic material. The light emitting element ED may be disposed between two electrodes facing each other and may emit light in response to electrical signals received from the electrodes.

The light emitting element ED according to the embodiment may extend in a direction. The light emitting element ED may be shaped like a cylinder, a rod, a wire, a tube, or the like. However, the shape of the light emitting element ED is not limited thereto, and the light emitting element ED may have various shapes including polygonal prisms, such as a cube, a rectangular parallelepiped or a hexagonal prism, or a shape extending in a direction and having a partially inclined outer surface.

The light emitting element ED may include a semiconductor layer doped with a dopant of a conductivity type (e.g., a $p$ type or an $n$ type). The semiconductor layer may receive an electrical signal from an external power source and emit light of a specific wavelength band. The light emitting element ED includes a first semiconductor layer 31, a second semiconductor layer 32, an active layer 36, an electrode layer 37, and an insulating film 38.

The first semiconductor layer 31 may be an n-type semiconductor. The first semiconductor layer 31 may include a semiconductor material having a chemical formula of $Al_xGa_yIn_{1-x-y}N$ ($0{\le}x{\le}1$, $0{\le}y{\le}1$, $0{\le}x+y{\le}1$). For example, the first semiconductor layer 31 may include at least one of AlGaInN, GaN, AlGaN, InGaN, AlN, and InN doped with an n-type dopant. The n-type dopant used to dope the first semiconductor layer 31 may be Si, Ge, Sn, or the like.

The second semiconductor layer 32 is disposed on the first semiconductor layer 31 with the active layer 36 interposed between the second semiconductor layer 32 and the first semiconductor layer 31. The second semiconductor layer 32 may be a p-type semiconductor. The second semiconductor layer 32 may include a semiconductor material having a chemical formula of $Al_xGa_yIn_{1-x-y}N$ ($0{\le}x{\le}1$, $0{\le}y{\le}1$, $0{\le}x+y{\le}1$). For example, the second semiconductor layer 32 may include at least one of AlGaInN, GaN, AlGaN, InGaN, AlN, and InN doped with a p-type dopant. The p-type dopant used to dope the second semiconductor layer 32 may be Mg, Zn, Ca, Ba, or the like.

Although FIG. 1 illustrates that each of the first semiconductor layer 31 and the second semiconductor layer 32 is composed of one layer, the disclosure is not limited thereto. Each of the first semiconductor layer 31 and the second semiconductor layer 32 may include more layers, for example, may further include a clad layer or a tensile strain barrier reducing (TSBR) layer depending on the material of the active layer 36. For example, the light emitting element ED may further include another semiconductor layer disposed between the first semiconductor layer 31 and the active layer 36 or between the second semiconductor layer 32 and the active layer 36. The semiconductor layer disposed between the first semiconductor layer 31 and the active layer 36 may include at least one of AlGaInN, GaN, AlGaN, InGaN, AlN, and InN doped with an n-type dopant. The semiconductor layer disposed between the second semiconductor layer 32 and the active layer 36 may include at least one of AlGaInN, GaN, AlGaN, InGaN, AlN, and InN doped with a p-type dopant.

The active layer 36 is disposed between the first semiconductor layer 31 and the second semiconductor layer 32. The active layer 36 may include a material having a single or multiple quantum well structure. In case that the active layer 36 includes a material having a multiple quantum well structure, the active layer 36 may have a structure in which multiple barrier layers and multiple well layers are alternately stacked each other. The active layer 36 may emit light through combination of electron-hole pairs according to electrical signals received through the first semiconductor layer 31 and the second semiconductor layer 32. The active layer 36 may include a material such as AlGaN, AlGaInN, or InGaN. For example, in case that the active layer 36 has a multiple quantum well structure in which barrier layers and well layers are alternately stacked each other, the barrier layers may include a material such as GaN or AlInN, and the well layers may include a material such as AlGaN or AlInGaN.

The active layer 36 may have a structure in which a semiconductor material having a large band gap energy and a semiconductor material having a small band gap energy are alternately stacked each other or may include a group 3 to 5 semiconductor material depending on the wavelength band of light that the active layer 36 emits. Light emitted from the active layer 36 is not limited to light in a blue wavelength band. In another embodiment, the active layer 36 may emit light in a red or green wavelength band. In an embodiment, the active layer 36 of the light emitting element ED may emit blue light having a main peak wavelength in a range of about 370 nm to about 460 nm.

The electrode layer 37 may be an ohmic connection electrode. However, the disclosure is not limited thereto, and the electrode layer 37 may be a Schottky connection electrode. The light emitting element ED may include at least one electrode layer 37. The light emitting element ED may include one or more electrode layers 37. However, the disclosure is not limited thereto, and the electrode layer 37 may also be omitted.

In case that the light emitting element ED is electrically connected to an electrode or a connection electrode, the electrode layer 37 may reduce the resistance between the light emitting element ED and the electrode or the connection electrode. The electrode layer 37 may include a conductive metal. For example, the electrode layer 37 may include at least one of aluminium (Al), titanium (Ti), indium (In), gold (Au), silver (Ag), indium tin oxide (ITO), indium zinc oxide (IZO), and indium tin zinc oxide (ITZO).

The insulating film 38 may surround outer surfaces of the semiconductor layers and the electrode layer described above. For example, the insulating film 38 surrounds an outer surface of at least the active layer 36, but may expose ends of the light emitting element ED in a longitudinal direction. In an embodiment, an upper surface of the insulating film 38 may be rounded in cross section in an area adjacent to at least one end of the light emitting element ED. As will be described below, the insulating film 38 may have a structure in which one or more layers of insulating materials are stacked each other.

The insulating film 38 may protect the semiconductor layers and the electrode layer of the light emitting element ED. The insulating film 38 may prevent an electrical short circuit that may occur in the active layer 36 in case that the active layer 36 directly contacts an electrode that transmits an electrical signal to the light emitting element ED. The insulating film 38 may prevent a reduction in luminous efficiency of the light emitting element ED.

In some embodiments, an outer surface of the insulating film 38 may be treated. The light emitting element ED may be sprayed onto electrodes in a state where the light emitting element ED is dispersed in an ink. The surface of the insulating film 38 may be hydrophobic or hydrophilic-treated so that the light emitting element ED may be kept separate in the ink without being agglomerated with other adjacent light emitting elements ED.

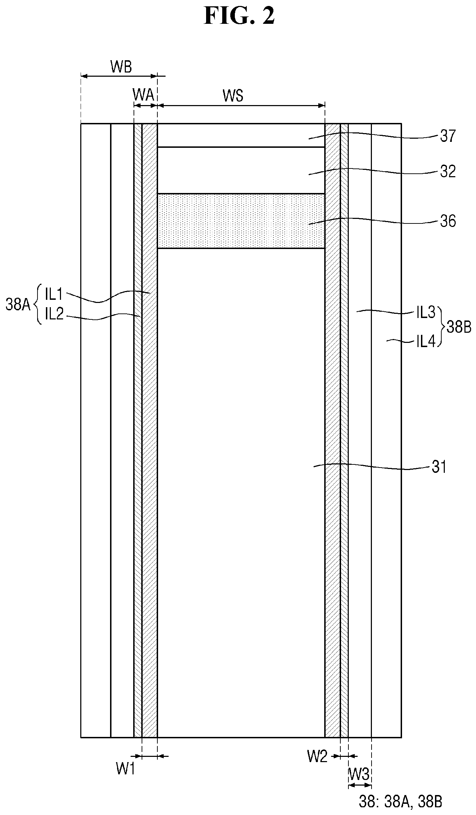

FIG. 2 is a schematic cross-sectional view of the light emitting element ED of FIG. 1.

Referring to FIG. 2 in addition to FIG. 1, in the light emitting element ED according to an embodiment, the insulating film 38 surrounding the semiconductor layers 31 and 32 and the active layer 36 may include one or more insulating layers. For example, the insulating film 38 may include a first insulating film 38A directly contacting side surfaces of the semiconductor layers 31 and 32 and the active layer 36 and a second insulating film 38B surrounding an outer surface of the first insulating film 38A. The first insulating film 38A may serve to prevent surface defects of the light emitting element ED. In case that the light emitting element ED is applied to a display device, the second insulating film 38B may prevent the light emitting element ED from being damaged during a process of manufacturing the display device.

According to an embodiment, the first insulating film 38A may include a first layer IL1 and a second layer IL2. The first layer IL1 may include zirconium oxide $(ZrO_2)$ or hafnium oxide $(HfO_2)$, and the second layer IL2 includes aluminium nitride (AlN). The first insulating film 38A may have a stacked structure of $ZrO_2$ and AlN or $HfO_2$ and AlN and may serve as a barrier that reduces defects formed on the surfaces of the semiconductor layers 31 and 32 and the active layer 36 while preventing the material of the second insulating film 38B from penetrating into the defects.

The first layer IL1 of the first insulating film 38A may include a material having crystallinity similar to the material (e.g., GaN) of the semiconductor layers 31 and 32. The first layer IL1 may be formed on the surfaces of the semiconductor layers 31 and 32 with excellent crystallinity by including zirconium oxide $(ZrO_2)$ or hafnium oxide $(HfO_2)$.

The second layer IL2 of the first insulating film 38A may serve as a barrier layer that prevents damage occurring during deposition of the second insulating film 38B from reaching the surfaces of the semiconductor layer 31 and 32 and the active layer 36. The presence of the second layer IL2 may increase a distance between the second insulating film 38B and the surfaces of the semiconductor layers 31 and 32 and the active layer 36. The second layer IL2 includes AlN having a large band gap, may have excellent insulating properties, and may be deposited at a low temperature (e.g., 150 °C). Therefore, the second layer IL2 may minimize defects formed on the surface. In an embodiment, a thickness W1 or W2 of each of the first layer IL1 and the second layer IL2 may be in a range of about 1 nm to about 3 nm. For example, a thickness W1 or W2 of each of the first layer IL1 and the second layer IL2 may be about 2 nm. Accordingly, a total thickness WA of the first insulating film 38A may be in a range of about 2 nm to about 6 nm.

The second insulating film 38B may include a third layer IL3 surrounding the first insulating film 38A and a fourth layer IL4 surrounding the third layer IL3. The fourth layer IL4 may be an outermost insulating layer of the insulating film 38 and may prevent the light emitting element ED from being damaged during a process of manufacturing a display device including the light emitting element ED. When the fourth layer IL4 is formed, the third layer IL3 may prevent a metal component included in the fourth layer IL4 from diffusing into the first insulating film 38A to form defects. In an embodiment, the third layer IL3 and the fourth layer IL4 of the second insulating film 38B may each include a material having insulating properties, for example, at least one of silicon oxide ($SiO_x$), silicon nitride ($SiN_x$), silicon oxynitride ($SiO_xN_y$), aluminium nitride ($AlN_x$), aluminium oxide ($AlO_x$), zirconium oxide ($ZrO_x$), hafnium oxide ($HfO_x$), and titanium oxide ($TiO_x$). For example, the third layer IL3 may include silicon oxide ($SiO_x$), and the fourth layer IL4 may include aluminium oxide ($Al_2O_3$). However, the disclosure is not limited thereto.

In an embodiment, the third layer IL3 of the second insulating film 38B may have a thickness W3 greater than or equal to about 10 nm, and the fourth layer IL4 may have a thickness in a range of about 40 nm to about 100 nm. The third layer IL3 may have a thickness sufficient to prevent the metal component of the fourth layer IL4 from diffusing into the first insulating film 38A. The fourth layer IL4 may have a thickness sufficient to prevent damage to the light emitting element ED during a process of manufacturing a display device. In an embodiment, in the light emitting element ED, a diameter WS of each of the semiconductor layers 31 and 32 may be in a range of about 0.5 $\mu$m to about 10 $\mu$m, the second insulating film 38B may have a thickness of at least 50 nm, and the insulating film 38 may have a thickness WB of at least 52 nm. If the insulating film 38 of the light emitting element ED has a thickness of less than 52 nm, the effect of protecting the light emitting element ED and improving the optical characteristics of the light emitting element ED may be reduced. If the insulating film 38 of the light emitting element ED is too thick, a diameter of the light emitting element ED may be too large, making it difficult to apply the light emitting element ED to a display device 10. The light emitting element ED may have better electrical characteristics as the thickness of the insulating film 38 increases. For example, one or more layers of insulating films 38 may be stacked in the light emitting element ED.

The light emitting element ED according to the embodiment may have improved optical characteristics and may have low leakage current below a threshold voltage. In an embodiment, in the light emitting element ED, the diameter of each of the semiconductor layers 31 and 32 may be in a range of about 0.5 $\mu$m to about 10 $\mu$m.

In an embodiment, the insulating film 38 of the light emitting element ED may be formed through a sol-gel process and may reduce or minimize defects that may be formed on the surfaces of the semiconductor layers 31 and 32 and the active layer 36.

A lot of defects, such as dangling bonds, defects caused by strain relaxation, or damage caused by an etching process, may occur on surfaces exposed in a process of etching semiconductor material layers. The defects formed in semiconductor layers of a light emitting element ED may be a factor that reduces the luminous efficiency of the light emitting element ED. However, an insulating film 38 surrounding the semiconductor layers may minimize a reduction in luminous efficiency by reducing damage caused by the defects or curing the damage. A process of forming the insulating film 38 may be a chemical process involving a thermal process and a plasma process and may be performed by a process such as chemical vapor deposition (CVD) or atomic layer deposition (ALD). However, as the above processes proceed in the process of forming the insulating film 38, semiconductor layer surfaces may be exposed to an environment vulnerable to defects, and the defect mitigation effect brought about by the formation of the insulating film 38 may be reduced.

In the light emitting element ED according to the embodiment, the insulating film 38 may be formed through a sol-gel process that does not include a thermal process or a plasma process, unlike chemical vapor deposition or atomic layer deposition. Since the insulating film 38 of the light emitting element ED is formed through a sol-gel process, the insulating film 38 may be formed by being adsorbed on the surfaces of the semiconductor layers 31 and 32 and the active layer 36 without an interatomic bonding reaction, unlike in other chemical deposition processes. Accordingly, defects and dangling bonds that may be generated on the surfaces of the semiconductor layers 31 and 32 and the active layer 36 of the light emitting element ED may be minimized.

The light emitting element ED may be grown on a substrate through an epitaxial growth method. In some embodiments, the semiconductor layers 31 and 32, the active layer 36, and the electrode layer 37 of the light emitting element ED may be formed as semiconductor material layers made of the material described above, respectively, and stacked sequentially are etched along a mask pattern in a direction in which they are stacked, for example, in a direction perpendicular to the growth substrate. In the process of etching the semiconductor material layers, defects may occur on the etched and exposed surfaces of the semiconductor layers 31 and 32 and the active layer 36.

The light emitting element ED according to the embodiment may have a relatively small diameter and size. The smaller the size of the light emitting element ED, the greater the influence of surface defects that may be formed in the semiconductor layers 31 and 32 and the active layer 36 in the process of manufacturing the light emitting element ED. For example, in case that the diameter of the light emitting element ED is greater than or equal to about 100 $\mu$m, element characteristics may be hardly changed by surface defects formed during the manufacturing process because the diameter is larger than the surface defects. However, in the light emitting element ED according to the embodiment, the semiconductor layers may have a diameter less than or equal to about 10 $\mu$m, and the ratio of surface defects to the diameter of the light emitting element ED may increase, which may affect the element characteristics.

Defects formed in the semiconductor layers 31 and 32 and the active layer 36 of the light emitting element ED may affect the electrical and optical characteristics of the light emitting element ED, and consequently, may affect the luminous efficiency of the display device 10. If the defects formed on the surfaces of the semiconductor layers 31 and 32 and the active layer 36 can be reduced or controlled, the electrical and optical characteristics of the light emitting element ED may be improved, and the luminous efficiency of the display device 10 may also be improved.

For example, surface defects formed in the semiconductor layers 31 and 32 and the active layer 36 of the light emitting element ED may cause afterimages following light emission of the light emitting element or delays in restoration time. As the surface defects formed in the light emitting element ED, defects formed at an interface between the surfaces of the semiconductor layers 31 and 32 and the active layer 36 and the insulating film 38 may cause trapping-detrapping of moving charges. In case that charges are trapped in defects formed on the surfaces while moving through the semiconductor layers 31 and 32 and the active layer 36, normal light emission may be delayed, or luminous efficiency may be reduced. In case that a driving signal transmitted to the light emitting element ED is changed, the time taken to return to the luminance in case that an immediately previous driving signal was transmitted may be delayed in a process in which the trapped charges are de-trapped. Accordingly, this may cause afterimages.

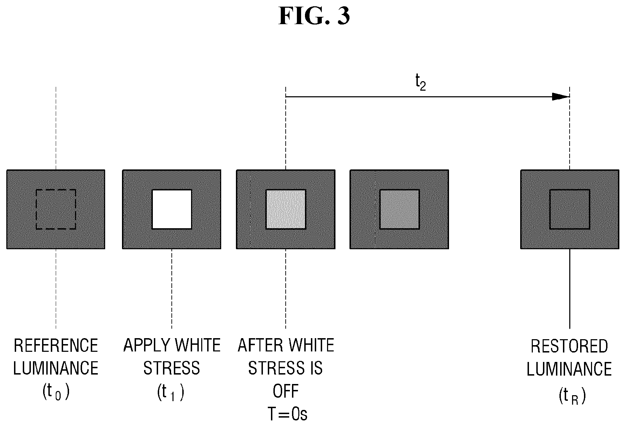

FIG. 3 is a schematic diagram illustrating an afterimage phenomenon following light emission of the light emitting element ED according to the embodiment.

Referring to FIG. 3, the luminance of light emitted from the light emitting element ED at a first time $t_0$ that a first driving signal is transmitted to the light emitting element ED may be defined as reference luminance. The luminance of the light emitted from the light emitting element ED may change at a second time $t_1$ that a second driving signal is transmitted to the light emitting element ED. The time taken to reach theoretical luminance of the light emitted from the light emitting element ED according to the second driving signal may be delayed by surface defects of the light emitting element ED. In an embodiment, referring to FIG. 3, 'white stress' may be applied at the second time $t_1$ so that the light emitting element ED emits white (255G) light according to the second driving signal.

At a third time $t_2$ that the first driving signal is transmitted to the light emitting element ED again, the white stress applied to the light emitting element ED may be stopped, and the theoretical luminance of the light emitted from the light emitting element ED and the reference luminance at the first time $t_0$ may be the same. However, the time taken to reach the reference luminance or restored luminance may be delayed by the surface defects formed in the light emitting element ED. The time between a fourth time $t_R$ that the restored luminance is reached and the third time $t_2$ may be defined as restoration time. The more surface defects in the light emitting element ED, the more delayed the normal light emission time from the first time $t_0$ having the reference luminance to the second time $t_1$ that white light is emitted according to the second driving signal, and the restoration time from the third time $t_2$ that the white stress is stopped to the fourth time $t_R$ that the restored luminance is reached may be delayed.

The light emitting element ED according to the embodiment may reduce or minimize defects that may be formed on the surface by the structure of the insulating film 38 surrounding the surfaces of the semiconductor layers 31 and 32 and the active layer 36 and through the process of forming the insulating film 38 or a manufacturing process using an epitaxial growth method. Accordingly, the light emitting element ED according to the embodiment may show a rapid luminance change according to a driving signal change even if its diameter is small, for example, even if the diameter of each of the semiconductor layers 31 and 32 of the light emitting element ED is less than or equal to about 10 $\mu$m.

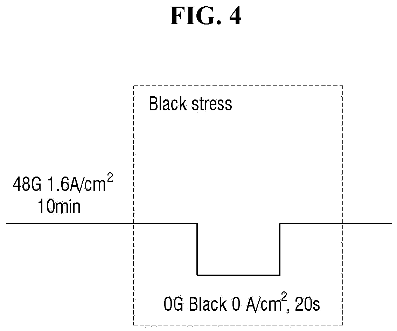

FIG. 4 is a graph illustrating a current signal transmitted to the light emitting element ED according to the embodiment during black stress evaluation of the light emitting element ED.

In order to evaluate the afterimage phenomenon of the light emitting element ED, a temporary pixel including the light emitting element ED was manufactured, and a driving current signal was transmitted to the light emitting element ED to measure a luminance change of light emitted from the light emitting element ED.

In the specification, 'reference luminance', 'restored luminance', and 'restoration time' may be defined in the evaluation of the afterimage phenomenon of the light emitting element ED. The 'reference luminance' may be luminance arbitrarily set for afterimage evaluation and may be the luminance of light emitted in case that a specific driving current, for example, a first driving current is supplied. The intensity of the driving current and the luminance of the light may be arbitrarily set values and may be set to evaluate the afterimage phenomenon. The first driving current may be a current supplied before/after a specific condition, for example, black stress or white stress is applied. The first driving current may be a standard for measuring the time taken for the light emitting element ED, which was emitting light of the reference luminance before the specific condition is applied, to emit light close to the reference luminance after the specific condition is applied.

The 'restored luminance' may be defined as in Equation 1 below.

[Equation 1]

$$0.99 \text{ x reference luminance} < \text{restored luminance} < 1.01 \text{ x reference luminance}$$

In Equation 1 above, the reference luminance may be, as described above, defined as the luminance of light emitted from the light emitting element ED in case that the first driving current is supplied, and the restored luminance may be defined as luminance of an intensity close to the reference luminance. The restored luminance may be set to an intensity within about 1% of the intensity of the reference luminance, and the value '1%' may be an arbitrarily set value. The value '1%' may be a value set to provide a user of the light emitting element ED and a display device including the light emitting element ED with a smooth screen in which screen transitions or changes in light intensity are not readily recognized.

The afterimage evaluation of the light emitting element ED may be performed by supplying the first driving current to cause emission of light of the reference luminance, supplying the first driving current again after applying a specific condition (black stress and white stress), and measuring the time taken from when the first driving current begins to be supplied again or the end of the specific condition to the emission of light of the restored luminance. The time taken from the end of the specific condition to the emission of the light of the restored luminance may be defined as 'restoration time'. As the restoration time decreases, the afterimage phenomenon of the light emitting element ED may be reduced, and a display device including the light emitting element ED may provide a user with a screen that allows smooth transitions.

As will be described below, the specific condition may be achieved by turning off the light emitting element ED or supplying a second driving current of an intensity different from the intensity of the first driving current so that light of maximum luminance is emitted. Turning off the light emitting element ED that is emitting light of the reference luminance may be applying 'black stress', and making the light emitting element ED to emit light of the maximum luminance may be applying 'white stress'.

Referring to FIG. 4, first, the light emitting element ED is made to emit light 48 G by supplying a first driving current of 1.6 A/cm$^2$ to the light emitting element ED for at least 10 minutes. The luminance of the light emitted from the light emitting element ED to which the first driving current is supplied may be the reference luminance. A second driving current of a different intensity is supplied for a time to the light emitting element ED which is emitting the light of the reference luminance for more than 10 minutes, and the first driving current is supplied again to cause the light emitting element ED to emit light with the reference luminance. As illustrated in FIG. 4, the second driving current of 0 A/cm$^2$ was supplied to the light emitting element ED for 20 seconds (black stress), and the first driving current of 1.6 A/cm$^2$ was supplied again. Supplying the second driving current of 0 A/cm$^2$ is actually not supplying a current to the light emitting element ED and may be a process of turning off the light emitting element ED. By turning off the light emitting element ED which is emitting light of the reference luminance and supplying the first driving current to cause the light emitting element ED to emit light of the reference luminance again, it is possible to evaluate the time taken for the light emitting element ED to return to the reference luminance after being turned off (black stress evaluation).

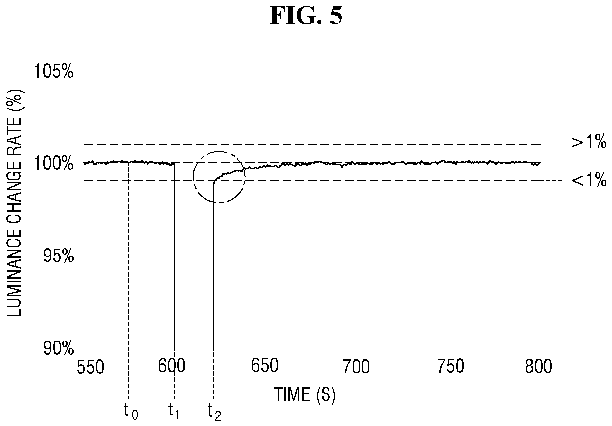

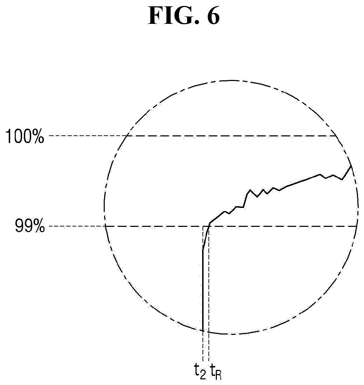

FIG. 5 is a schematic graph illustrating the luminance change rate of light emitted from the light emitting element ED over time in the experiment conducted in FIG. 4. FIG. 6 is an enlarged view of a luminance change rate portion during the restoration time in the graph of FIG. 5.

Referring to FIGS. 5 and 6, at a first time $t_0$, the first driving current of FIG. 4 is supplied to the light emitting element ED. Therefore, the light emitting element ED may emit light of the reference luminance. At a second time $t_1$, the light emitting element ED may be turned off. After the light emitting element ED is turned off for about 20 seconds, the first driving current is supplied again to the light emitting element ED at a third time $t_2$. The luminance fraction of the reference luminance emitted from the light emitting element ED is set to 100%, and the change in the luminance fraction with respect to the change in the intensity of the current supplied to the light emitting element ED is illustrated in FIGS. 5 and 6.

As the light emitting element ED is turned off at the second time $t_1$ of FIG. 5, the luminance fraction decreases to 0%. As the first driving current is supplied again to the light emitting element ED at the third time $t_2$, light emitted from the light emitting element ED gradually reaches the reference luminance or the luminance fraction of 100%. Here, the time taken to reach the restored luminance according to Equation 1, which is luminance within about 1% of the luminance fraction of 100% of the reference luminance, is set as restoration time $t_R$. As illustrated in FIG. 6, it can be seen that the restoration time $t_R$ taken for the light emitting element ED to reach the restored luminance in response to the first driving current supplied again after the light emitting element ED is turned off (after black stress is applied) is less than or equal to about 10 seconds. For example, the restoration time $t_R$ taken for the light emitting element ED to reach the restored luminance in response to the first driving current supplied again after the light emitting element ED is turned off (after black stress is applied) is less than or equal to about 1 second.

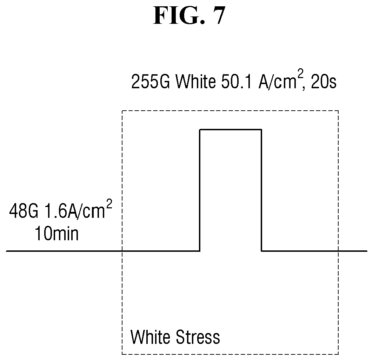

FIG. 7 is a graph illustrating a current signal transmitted to the light emitting element ED according to the embodiment during white stress evaluation of the light emitting element ED.

Referring to FIG. 7, first, the light emitting element ED is made to emit light 48G by supplying a first driving current of 1.6 A/cm$^2$ to the light emitting element ED for at least 10 minutes. The luminance of the light emitted from the light emitting element ED to which the first driving current is supplied may be the reference luminance. A second driving current of a different intensity is supplied for a time to the light emitting element ED which is emitting the light of the reference luminance for more than 10 minutes, and the first driving current is supplied again to cause the light emitting element ED to emit light with the reference luminance. As illustrated in FIG. 7, the second driving current of 50.1 A/cm$^2$ was supplied to the light emitting element ED for 20 seconds (white stress), and the first driving current of 1.6 A/cm$^2$ was supplied again. Supplying the second driving current may be a process of supplying a strong current to the light emitting element ED to make the light emitting element ED emit light with the maximum luminance 255G. By causing the light emitting element ED, which is emitting light of the reference luminance, to emit light of the maximum luminance and supplying the first driving current to cause the light emitting element ED to emit light of the reference luminance again, it is possible to evaluate the time taken for the light emitting element ED to return to the reference luminance after emitting light of the maximum luminance (white stress evaluation).

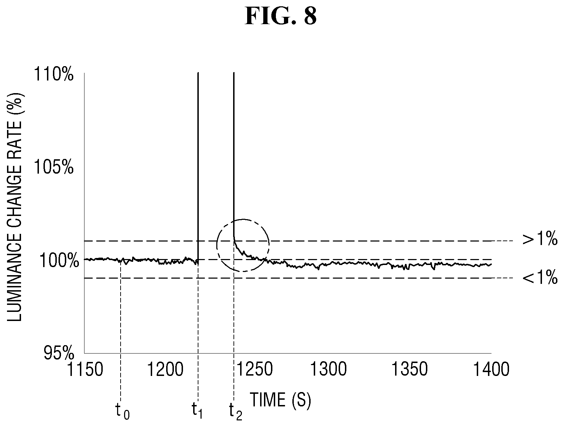

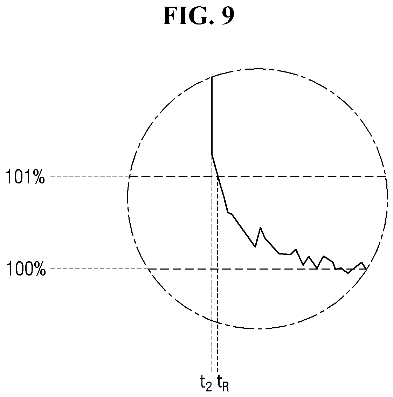

FIG. 8 is a schematic graph illustrating the luminance change rate of light emitted from the light emitting element ED over time in the experiment conducted in FIG. 7. FIG. 9 is an enlarged view of a luminance change rate portion during the restoration time in the graph of FIG. 8.

Referring to FIGS. 8 and 9, at a first time $t_0$, the first driving current of FIG. 7 is supplied to the light emitting element ED. Therefore, the light emitting element ED may emit light of the reference luminance. At a second time $t_1$, the light emitting element ED may be made to emit light with the maximum luminance by supplying the second driving current. After the light emitting element ED emits light for about 20 seconds, the first driving current is supplied again to the light emitting element ED at a third time $t_2$. The luminance fraction of the reference luminance emitted from the light emitting element ED is set to 100%, and the change in the luminance fraction with respect to the change in the intensity of the current supplied to the light emitting element ED is illustrated in FIGS. 8 and 9.

As the light emitting element ED emits light with the maximum luminance at the second time $t_1$ of FIG. 8, the luminance fraction increases to a large value. As the first driving current is supplied again to the light emitting element ED at the third time $t_2$, light emitted from the light emitting element ED gradually reaches the reference luminance or the luminance fraction of 100%. Here, the time taken to reach the restored luminance, which is luminance within about 1% of the luminance fraction of 100% of the reference luminance, is set as restoration time $t_R$. As illustrated in FIG. 9, it can be seen that the restoration time $t_R$ taken for the light emitting element ED to reach the restored luminance in response to the first driving current supplied again after the light emitting element ED emits light with the maximum luminance (after white stress is applied) is less than or equal to about 10 seconds. For example, the restoration time $t_R$ taken for the light emitting element ED to reach the restored luminance in response to the first driving current supplied again after the light emitting element ED emits light with the maximum luminance (after white stress is applied) is less than or equal to about 1 second.

In the light emitting element ED according to the embodiment, the insulating film 38 may include an AlN layer as the second layer IL2. Therefore, side defects may be significantly compensated for, and additional defect formation may be prevented in a subsequent process of forming the second insulating film 38B. Accordingly, although the light emitting element ED has a small diameter of tens of micrometers or less, defects formed on side surfaces may be partially compensated for by the insulating film 38, and the amount of electrons trapped in the defects may be reduced. Consequently, the insulating film 38 may reduce the afterimage or light emission delay phenomenon of the light emitting element ED.

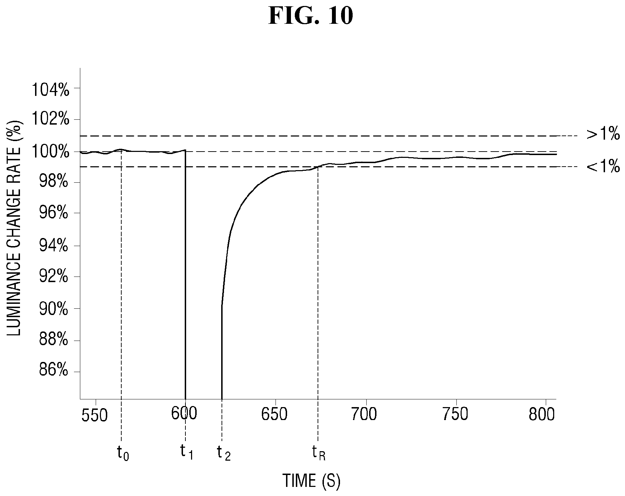

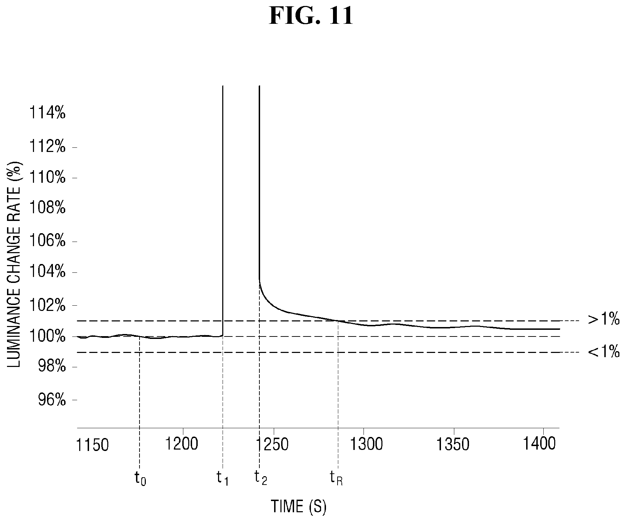

FIGS. 10 and 11 are graphs illustrating the restoration time of a light emitting element.

FIGS. 10 and 11 respectively show the results of conducting the afterimage evaluations of FIGS. 4 and 7 using another light emitting element. The light emitting element used in the evaluations of FIGS. 10 and 11 is different from the light emitting element ED of the disclosure in that an insulating film 38 does not include a second layer IL2. In other words, the light emitting element used in the evaluations of FIGS. 10 and 11 may include a $HfO_2/SiO_2/Al_2O_3$ insulating film 38 including a first layer of $HfO_2$, a third layer of $SiO_2$, and a fourth layer of $Al_2O_3$.

Referring to FIGS. 10 and 11, side defects of the light emitting element ED in which the insulating film 38 does not include an AlN layer as the second layer IL2 are hardly compensated for, and many side defects may occur in a $SiO_2$ formation process performed after $HfO_2$ of the first layer is formed. Accordingly, in case that the light emitting element ED is driven, many charges may be trapped in the side defects, causing an afterimage phenomenon. As apparent from the graphs of FIGS. 10 and 11, the restoration time of the light emitting element ED having a diameter of 10 $\mu$m or less is greater than 50 seconds or greater than 100 seconds.

On the other hand, as described above, in the light emitting element ED according to the embodiment, the insulating film 38 may include an AlN layer as the second layer IL2. Therefore, the afterimage or light emission delay phenomenon of the light emitting element ED may be reduced.

A method of manufacturing a light emitting element according to an embodiment will now be described.

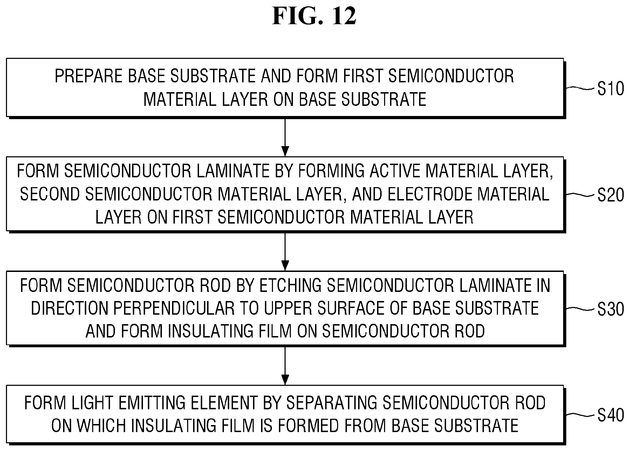

FIG. 12 is a flowchart illustrating a method of manufacturing a light emitting element according to an embodiment.

Referring to FIG. 12, the method of manufacturing the light emitting element according to an embodiment may include preparing a base substrate and forming a first semiconductor material layer on the base substrate (operation S10), forming a semiconductor laminate by forming an active material layer, a second semiconductor material layer, and an electrode material layer on the first semiconductor material layer (operation S20), forming a semiconductor rod by etching the semiconductor laminate in a direction perpendicular to an upper surface of the base substrate and forming an insulating film on side surfaces of the semiconductor rod (operation S30), and forming a light emitting element by separating the semiconductor rod on which the insulating film is formed from the base substrate (operation S40).

The method of manufacturing the light emitting element ED may include etching and separating the semiconductor laminate after forming the semiconductor laminate on the base substrate. An insulating film composed of multiple layers may be formed in the process of forming the insulating film to compensate for side defects of the etched semiconductor rod. The method of manufacturing the light emitting element will be described in detail below with further reference to other drawings.

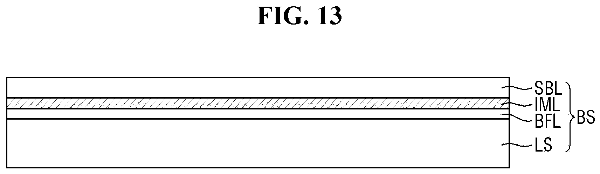

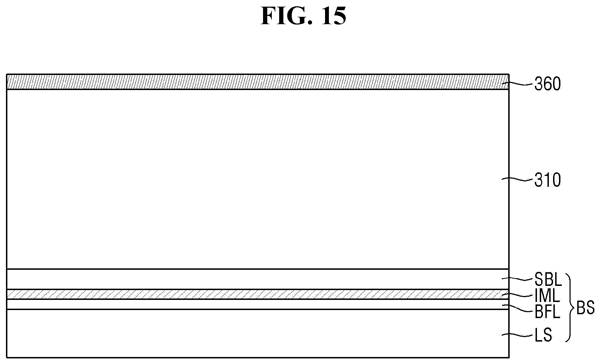

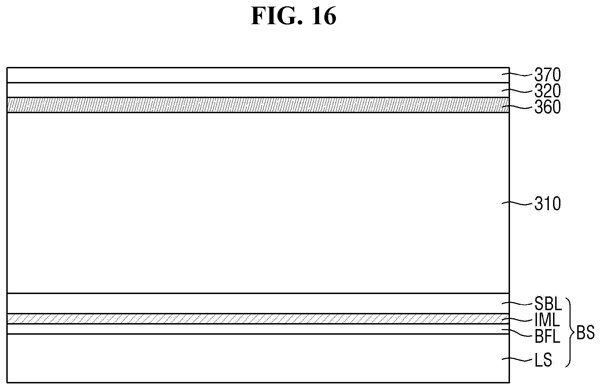

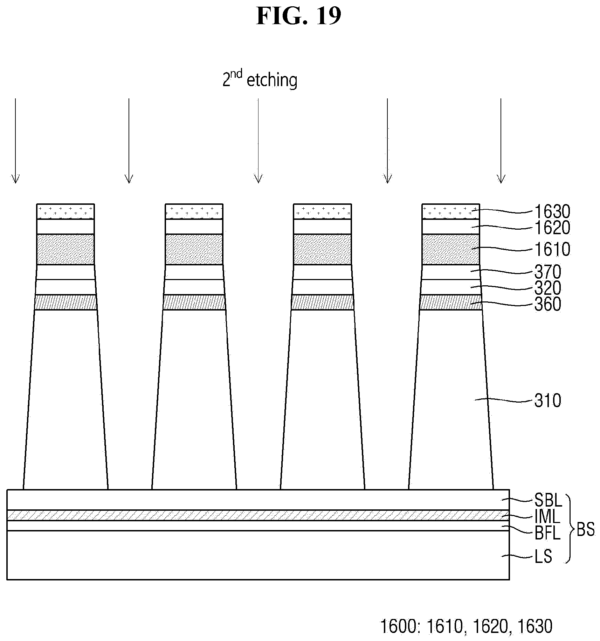

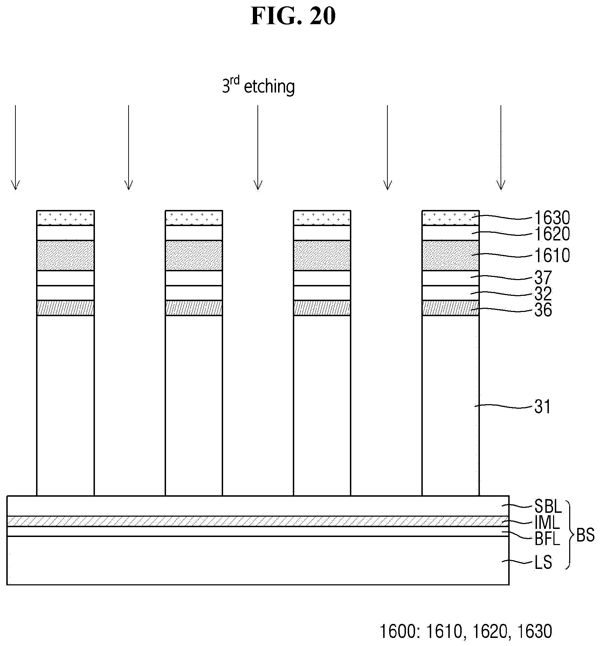

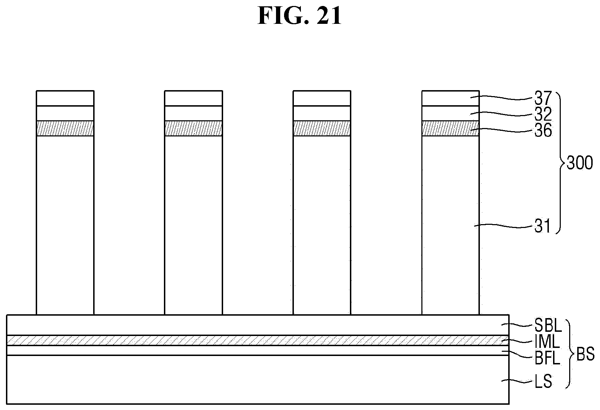

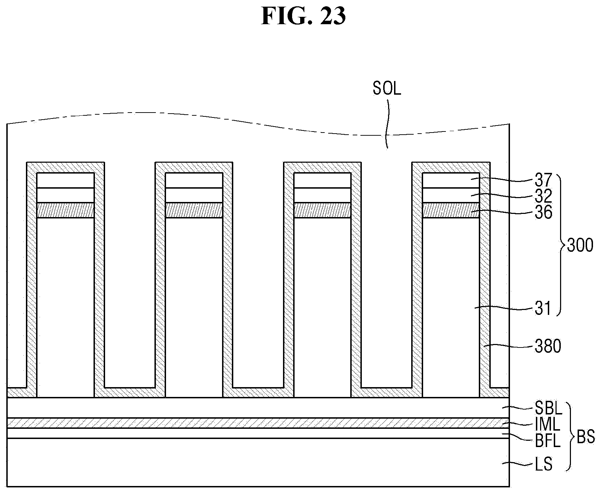

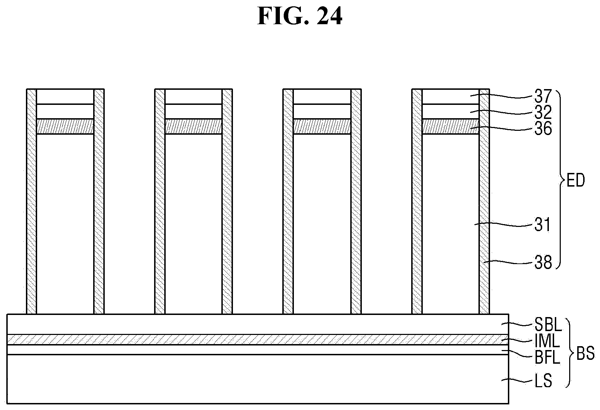

FIGS. 13 through 25 are schematic cross-sectional views sequentially illustrating a process of manufacturing light emitting elements according to an embodiment.

Referring to FIG. 13, a base substrate BS on which a semiconductor laminate is to be formed may be prepared. The base substrate BS may include a lower substrate LS, a buffer material layer BFL, an intermediate layer IML, and a semiconductor base layer SBL.

The lower substrate LS may be a transparent substrate including a sapphire ($Al_2O_3$) or glass. However, the disclosure is not limited thereto, and in another embodiment, the lower substrate LS may be formed of a conductive material such as GaN, SiC, ZnO, Si, GaP, or GaAs. A thickness of the lower substrate LS is not particularly limited. In an embodiment, the thickness of the lower substrate LS may be, for example, in a range of about 400 $\mu$m to about 1500 $\mu$m.

The buffer material layer BFL may be disposed on the lower substrate LS to reduce a difference in lattice constant between a first semiconductor material layer 310 and the lower substrate LS. In an embodiment, the buffer material layer BFL may include, but is not limited to, at least one of InAlGaN, GaN, AlGaN, InGaN, AlN, and InN.

The intermediate layer IML may be disposed on the buffer material layer BFL to reduce the defect density of a semiconductor layer disposed on the intermediate layer IML. Since the intermediate layer IML is formed in the base substrate BS in the process of manufacturing the light emitting elements ED, the defect density of semiconductor material layers formed through an epitaxial growth process may be reduced, and the defect density of the light emitting elements ED finally manufactured may also be reduced. Accordingly, the intermediate layer IML may reduce factors that lower the external quantum efficiency of the light emitting elements ED. In an embodiment, the intermediate layer IML may include AlN or $SiN_x$.

The semiconductor base layer SBL may provide seed crystals on which a semiconductor laminate can be grown. For example, the semiconductor base layer SBL may include an undoped semiconductor. The semiconductor base layer SBL and the first semiconductor material layer 310 may include substantially the same material, but the semiconductor base layer may be not doped with an $n$ type or $p$ type or may have a doping concentration lower than a doping concentration of the first semiconductor material layer 310. For example, the semiconductor base layer SBL may include undoped GaN.

In an embodiment, in the method of manufacturing the light emitting elements ED, the intermediate layer IML may be formed in the base substrate BS, and the defect density of the semiconductor base layer SBL may be low. For example, the defect density of the semiconductor base layer SBL including an undoped semiconductor may be less than or equal to about $1.0 * 10^8/cm^2$. For example, the defect density of the semiconductor base layer SBL including an undoped semiconductor may be less than or equal to about $6 * 10^7/cm^2$.

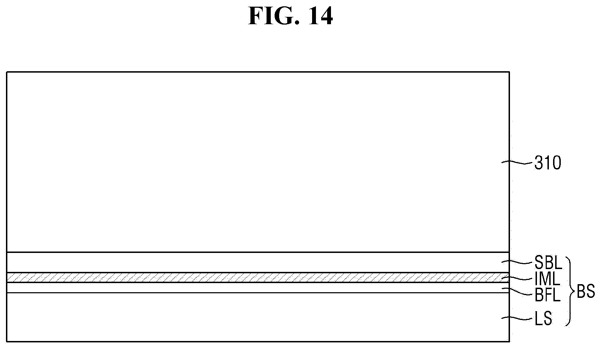

Referring to FIGS. 14 through 16, the first semiconductor material layer 310, an active material layer 360, a second semiconductor material layer 320, and an electrode material layer 370 may be sequentially formed on the semiconductor base layer SBL of the base substrate BS.

Multiple semiconductor material layers may be formed by growing seed crystals using an epitaxial method. The semiconductor material layers may be formed by electron beam deposition, physical vapor deposition (PVD), chemical vapor deposition (CVD), plasma laser deposition (PLD), dual-type thermal evaporation, sputtering, or metal organic chemical vapor deposition (MOCVD). In an embodiment, the semiconductor material layers may be formed by MOCVD, but the disclosure is not limited thereto.

A precursor material for forming the semiconductor material layers is not particularly limited to materials that can be generally selected to form a target material. For example, the precursor material may include a metal precursor including an alkyl group such as a methyl group or an ethyl group. For example, in an embodiment in which a first semiconductor layer 31, a second semiconductor layer 32, and an active layer 36 include at least one of AlGaInN, GaN, AlGaN, InGaN, AlN, and InN, as in the light emitting element ED according to the embodiment, the metal precursor may be trimethyl gallium ($Ga(CH_3)_3$) or may be a compound such as trimethyl aluminium ($Al(CH_3)_3$) or triethyl phosphate ($(C_2H_5)_3PO_4$). However, the disclosure is not limited thereto. In another embodiment, the semiconductor material layers may be formed through a deposition process using a metal precursor and a non-metal precursor.

The layers disposed on the base substrate BS may correspond to the semiconductor layers 31 and 32, the active layer 36, and an electrode layer 37 of each light emitting element ED, respectively. For example, the first semiconductor material layer 310 may correspond to the first semiconductor layer 31, and the active material layer 360 and the second semiconductor material layer 320 may correspond to the active layer 36 and the second semiconductor layer 32, respectively. For example, the material layers may include the same material as the semiconductor layers 31 and 32 and the active layer 36 of each light emitting element ED, respectively.

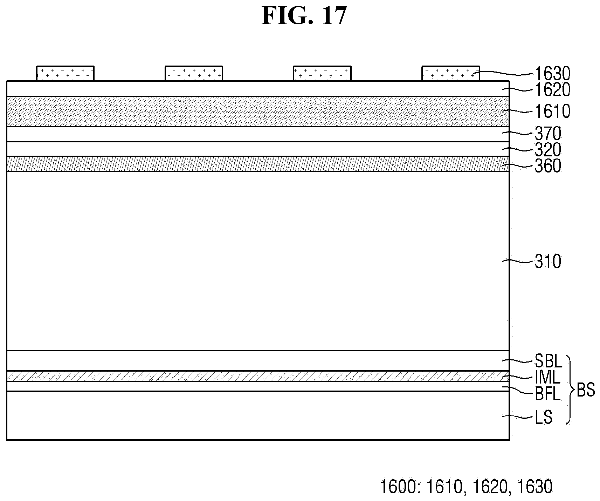

Referring to FIGS. 17 through 21, the semiconductor material layers 310 and 320, the active material layer 360, and the electrode material layer 370 may be etched to form semiconductor rods spaced apart from each other. According to an embodiment, the etching of the semiconductor material layers 310 and 320, the active material layer 360, and the electrode material layer 370 may include forming a mask layer on the electrode material layer 370 (first etching) and performing multiple etching processes (second etching and third etching) for etching the semiconductor material layers 310 and 320, etc. along the mask layer.

First, as illustrated in FIG. 17, multiple mask layers 1600 may be formed on the electrode material layer 370. The mask layers 1600 may include a first insulating mask layer 1610 and a second insulating mask layer 1620 disposed on the electrode material layer 370 and mask patterns 1630 disposed on the second insulating mask layer 1620. The first insulating mask layer 1610 and the second insulating mask layer 1620 may be etched in a subsequent process along spaces between the mask patterns 1630. The semiconductor material layers 310, 320, the active material layer 360 and the electrode material layer 370 may be etched along spaces between portions of the insulating mask layers 1610 and 1620 and between the mask patterns 1630. In some embodiments, the mask patterns 1630 may have a same diameter or width. Portions of the semiconductor material layers 310 and 320 which are not etched by being overlapped the mask patterns 1630 in a thickness direction of the base substrate BS may form semiconductor rods that form the light emitting elements ED. The diameter of each mask pattern 1630 and a diameter of each light emitting element ED may be substantially the same. Since the mask patterns 1630 have a same diameter or width, the light emitting elements ED may also have substantially a same diameter.

The first insulating mask layer 1610 and the second insulating mask layer 1620 may include an insulating material, and the mask patterns 1630 may include a metal material. For example, each of the insulating mask layers 1610 and 1620 may include silicon oxide ($SiO_x$), silicon nitride ($SiN_x$), silicon oxynitride ($SiO_xN_y$), or the like. The mask patterns 1630 may include, but are not limited to, a metal such as chromium (Cr).

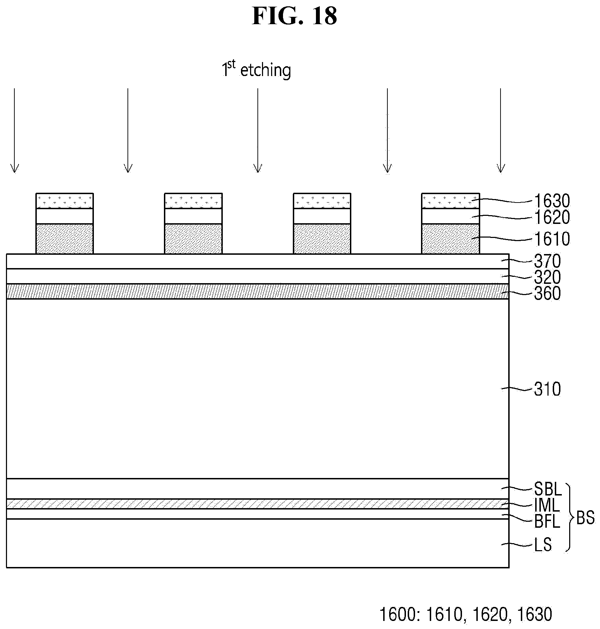

As illustrated in FIGS. 18 through 21, a first etching process for etching the insulating mask layers 1610 and 1620 along the mask patterns 1630 and second and third etching processes for etching the semiconductor material layers 310 and 320 along the etched insulating mask layers 1610 and 1620 may be performed. Each etching process may be performed in a direction perpendicular to an upper surface of the base substrate BS.

The above etching processes may be dry etching, wet etching, reactive ion etching (RIE), inductively coupled plasma reactive ion etching (ICP-RIE), or the like. The dry etching may be suitable for vertical etching because anisotropic etching is possible. In case that the above etching methods are used, an etchant may be, but is not limited to, $Cl_2$ or $O_2$.

The first etching process may be performed as a process of etching the insulating mask layers 1610 and 1620 exposed in areas between the mask patterns 1630 spaced apart from each other. The insulating mask layers 1610 and 1620 may be etched along the mask patterns 1630 and may function as a mask for etching the semiconductor material layers thereunder.

The semiconductor material layers may be etched using the mask patterns 1630 and the etched insulating mask layers 1610 and 1620 as a mask. The process of etching the semiconductor material layers may include a second etching process performed as a dry etching process and a third etching process which is a wet etching process performed after the second etching process.

In the second etching process, the semiconductor material layers may be etched in a direction perpendicular to the upper surface of the base substrate BS to form semiconductor rods spaced apart from each other. However, after the second etching process, side surfaces of the semiconductor rods may not be perpendicular but may be inclined with respect to the upper surface of the base substrate BS. The third etching process may be performed to make the side surfaces of the semiconductor rods perpendicular to the base substrate BS. The second etching process and the third etching process may be performed as dry etching and wet etching processes, respectively. The semiconductor rods spaced apart from each other may be formed on the base substrate BS by first, second, and third etching processes. Each of the semiconductor rods may include the first semiconductor material layer 310, the active material layer 360, the second semiconductor material layer 320, and the electrode material layer 370.

However, as described above, the side surfaces or surfaces of the semiconductor rods formed by the etching processes may be significantly damaged. Due to such surface damage, abnormal recombination may occur in semiconductor layers of the light emitting elements ED, and the light efficiency and electrical characteristics of the light emitting elements ED may deteriorate. In order to minimize such performance deterioration, each of the light emitting elements ED may include an insulating film 38 surrounding at least side surfaces of the semiconductor layers 31, 32, 36 and 37. For example, each of the light emitting elements ED according to an embodiment may include an insulating film 38 formed by a sol-gel process.

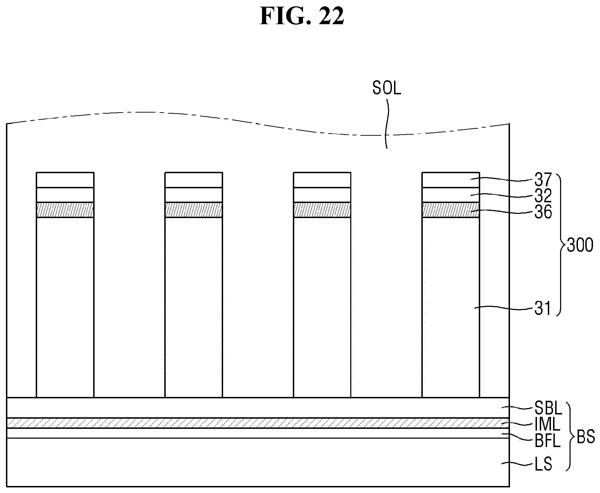

Referring to FIGS. 22 through 24, the insulating film 38 may be formed to partially surround the side surfaces of each of the semiconductor rods 300. The insulating film 38 may be formed by performing a process of forming an insulating material layer 380 to surround an outer surface of each of the semiconductor rods and partially removing the insulating material layer 380 to expose an upper surface of each of the semiconductor rods.

The insulating film 38 may be an insulating layer formed on the outer surface of each of the semiconductor rods 300 and may be formed using a method such as applying an insulating material on the outer surface of each vertically etched semiconductor rod 300 or immersing each semiconductor rod 300 in the insulating material. According to an embodiment, the insulating film 38 and/or the insulating material layer 380 may be formed through a sol-gel process.

The sol-gel process may be performed by immersing the semiconductor rods 300 or the semiconductor rods 300 and the base substrate BS in a solution SOL containing a precursor material that forms the insulating film 38 and/or the insulating material layer 380, adding other reactants, and stirring the solution SOL. The sol-gel process may have relatively mild process conditions compared with other chemical processes such as chemical vapor deposition and atomic layer deposition. For example, the sol-gel process may be performed by immersing the semiconductor rods 300 in the solution SOL containing the precursor material and adding a reactant to the solution SOL to cause a reaction at a low temperature.

In the drawings, the insulating film 38 is illustrated as a single layer. However, as described above, the insulating film 38 may include a first insulating film 38A and a second insulating film 38B, each including at least one layer. Since the layers of the first insulating film 38A and the second insulating film 38B include different materials, a process of causing a reaction in different solutions SOL may be repeated in the sol-gel process.

In some embodiments, the sol-gel process may be performed by immersing the semiconductor rods in the solution SOL and stirring the solution SOL at a temperature of about 25 °C for about 15 to 80 minutes. For example, the solution SOL may be stirred at about 25 °C for about 60 minutes. Since the sol-gel process is performed at a lower reaction temperature than other deposition processes, damage to the semiconductor rods may be reduced. For example, while other deposition processes require a high temperature process or a plasma irradiation process for the complete formation of the insulating material layer 380, the sol-gel process does not require the above processes. Therefore, the formation of defects in the semiconductor rods may be minimized.

A reaction time of the sol-gel process may vary according to the content of the precursor material and the reactant contained in the solution SOL, and a thickness of the insulating material layer 380 and/or the insulating film 38 formed on each of the semiconductor rods 300 may also vary according to the content of the precursor material and the reactant contained in the solution SOL. The reaction time of the sol-gel process may be a period of time during which all of the precursor material and the reactant in the solution SOL can react. In case that the precursor material has completely reacted, the thickness of the insulating material layer 380 and/or the insulating film 38 may no longer increase even if a process time of the sol-gel process increases. The process time of the sol-gel process may vary according to the thickness of each layer of the first insulating film 38A and the second insulating film 38B.

However, the disclosure is not limited thereto. In some embodiments, the process of forming the insulating material layer 380 may be performed by chemical vapor deposition or atomic layer deposition, or a process that minimizes surface defects. In some embodiments, the process of forming the insulating material layer 380 may be performed by a remote plasma ALD process. Since plasma for deposition is formed far away from the substrate, damage to the side surfaces of the semiconductor rods may be reduced.

The insulating material layer 380 formed through the sol-gel process may be formed on the side and upper surfaces of the semiconductor rods 300 and on the base substrate BS exposed in areas between the semiconductor rods 300. In order to remove the insulating material layer 380 disposed on the upper surfaces of the semiconductor rods 300 and in the areas between the semiconductor rods 300, a process such as dry etching, which is anisotropic etching, or etch-back may be performed. In some embodiments, an upper surface of the insulating material layer 380 may be removed to expose the electrode material layer 370. In this process, the electrode material layer 370 may also be partially etched. A thickness of the electrode layer 37 of each light emitting element ED finally manufactured may be smaller than a thickness of the electrode material layer 370 formed during the process of manufacturing the light emitting elements ED. After a portion of the insulating material layer 380 is removed, the insulating film 38 surrounding the side surfaces of the semiconductor layers in each light emitting element ED may be formed.

In the drawings, an upper surface of the electrode layer 37 is exposed, and an upper surface of the insulating film 38 is flat. However, the disclosure is not limited thereto. In some embodiments, the upper surface of the insulating film 38 may be partially curved in a portion surrounding the electrode layer 37. In the process of partially removing the insulating material layer 380, not only the upper surface but also side surfaces of the insulating material layer 380 may be partially removed. Therefore, the insulating film 38 surrounding the semiconductor layers may be formed to have a partially etched end surface. As the upper surface of the insulating material layer 380 is removed, an outer surface of the insulating film 38 adjacent to the electrode layer 37 in each light emitting element ED may be partially removed.

Although not illustrated in the drawings, after the light emitting elements ED are completed after the sol-gel process is performed on the base substrate BS, a process of heat-treating the light emitting elements ED may be further performed. Through the heat treatment process, the insulating films 38 of the light emitting elements ED may become more stable. The sol-gel process may be performed at a relatively low temperature. Therefore, if the insulating films 38 thus formed are heat-treated, the insulating films 38 of the light emitting elements ED may become more solid, and the optical characteristics of the light emitting elements ED may be improved as will be described below. In an embodiment, the heat treatment process may be performed at a temperature in a range of about 200 °C to about 300 °C. For example, the heat treatment process may be performed at a temperature of about 250 °C. In an embodiment, the heat treatment process may be performed for about 30 minutes to about 2 hours. For example, the heat treatment process may be performed for about 1 hour. However, the disclosure is not limited thereto.

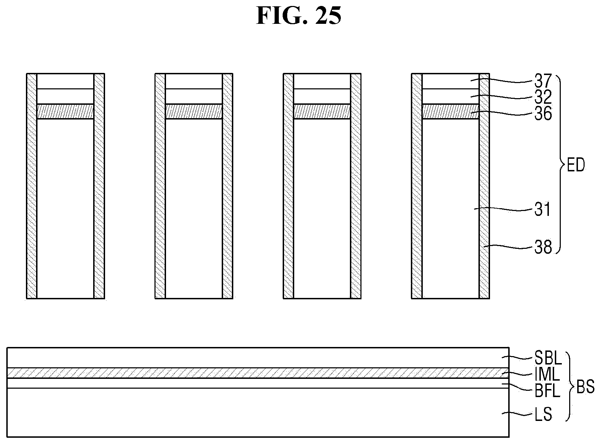

As illustrated in FIG. 25, the light emitting elements ED having the insulating films 38 may be separated from the base substrate BS.

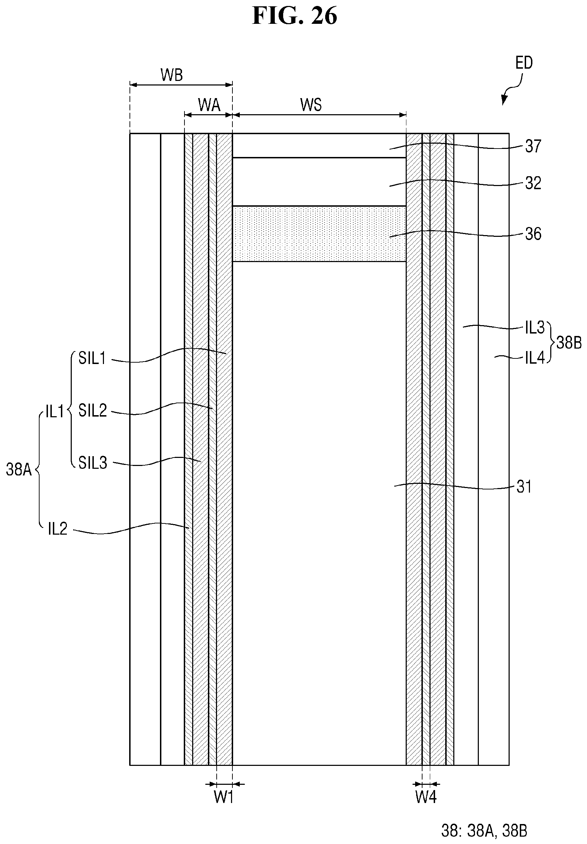

FIG. 26 is a schematic cross-sectional view of a light emitting element ED according to an embodiment.

Referring to FIG. 26, in the light emitting element ED according to an embodiment, a first layer IL1 of a first insulating film 38A may include multiple layers SIL1 through SIL3. The first layer IL1 may include a first sub-layer SIL1, a second sub-layer SIL2, and a third sub-layer SIL3 stacked on each other. The first sub-layer SIL1 and the third sub-layer SIL3 may each include zirconium oxide ($ZrO_2$), and the second sub-layer SIL2 may include aluminium oxide ($Al_2O_3$) or hafnium oxide ($HfO_2$). The first insulating film 38A may have a stacked structure of $ZrO_2/Al_2O_3/ZrO_2$ or $ZrO_2/HfO_2/ZrO_2$ and may serve as a barrier that reduces defects formed on surfaces of semiconductor layers 31 and 32 and an active layer 36 while preventing the material of a second insulating film 38B from penetrating into the defects.

The first insulating film 38A may include the third sub-layer SIL3 which covers the second sub-layer SIL2 to minimize a thickness of the second sub-layer SIL2. In a contact area between the first sub-layer SIL1 and the second sub-layer SIL2, metal components of the second sub-layer SIL2 may diffuse into the first sub-layer SIL1 to form defects. However, since the third sub-layer SIL3 including the same material as the first sub-layer SIL1 minimizes the thickness of the second sub-layer SIL2 by covering the second sub-layer SIL2, the defects may be reduced. In an embodiment, a thickness W1 of each of the first sub-layer SIL1 and the third sub-layer SIL3 may be about 2 nm, and a thickness W4 of each of the second sub-layer SIL2 and the third sub-layer SIL3 may be about 1 nm. Accordingly, a total thickness WA of the first insulating film 38A may be in a range of about 4 nm to about 5 nm.

Hereinafter, a display device including a light emitting element ED according to an embodiment and electronic devices to which the display device is applied will be described.

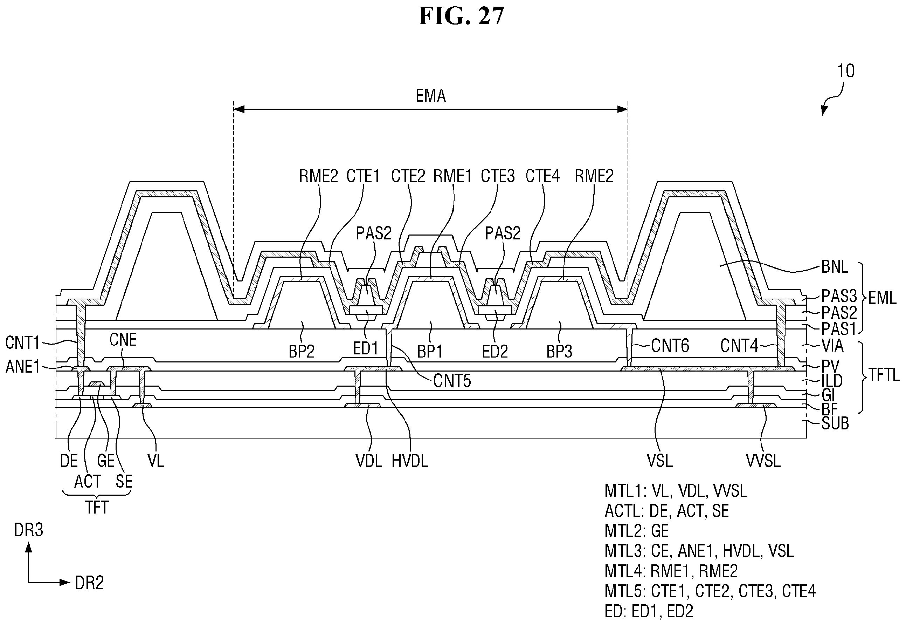

FIG. 27 is a schematic cross-sectional view of a display device 10 according to an embodiment.

Referring to FIG. 27, the display device 10 according to an embodiment may include a substrate SUB, a thin-film transistor layer TFTL, and a light emitting element layer EML. The display device 10 may emit light by light emitting elements ED disposed in the light emitting element layer EML.

The substrate SUB may be a base substrate or a base member. The substrate SUB may be a flexible substrate that can be bent, folded, rolled, etc. For example, the substrate SUB may include a glass material or a metal material, but the disclosure is not limited thereto. In another embodiment, the substrate SUB may include polymer resin including polyimide (PI) or the like.

The thin-film transistor layer TFTL may be disposed on the substrate SUB. The thin-film transistor layer TFTL may include a first metal layer MTL1, a buffer layer BF, an active layer ACTL, a gate insulating layer GI, a second metal layer MTL2, an interlayer insulating layer ILD, a third metal layer MTL3, a passivation layer PV, and a via layer VIA.

The first metal layer MTL1 may be disposed on the substrate SUB. The first metal layer MTL1 may include a voltage line VL, a first voltage line VDL, and a vertical voltage line VVSL. The voltage line VL may be the first voltage line VDL, an initialization voltage line, or a data line.

The buffer layer BF may be disposed on the first metal layer MTL1. For example, the buffer layer BF may include an inorganic layer that can prevent penetration of air or moisture. For example, the buffer layer BF may include multiple inorganic layers alternately stacked each other.

The active layer ACTL may be disposed on the buffer layer BF. The active layer ACTL may include a drain electrode DE, a semiconductor region ACT, and a source electrode SE of a thin-film transistor TFT. For example, the semiconductor region ACT of the thin-film transistor TFT may include low temperature polycrystalline silicon (LTPS). The thin-film transistor TFT including low temperature polycrystalline silicon may have high electron mobility and excellent turn-on characteristics. In another embodiment, the semiconductor region ACT of the thin-film transistor TFT may include an oxide semiconductor. The thin-film transistor TFT including an oxide semiconductor may have excellent leakage current characteristics and may reduce power consumption and can be driven at a low frequency.

The gate insulating layer GI may be disposed on the active layer ACTL. The gate insulating layer GI may insulate the active layer ACTL from the second metal layer MTL2.

The second metal layer MTL2 may be disposed on the gate insulating layer GI. The second metal layer MTL2 may include a gate electrode GE of the thin-film transistor TFT. The gate electrode GE of the thin-film transistor TFT may overlap the semiconductor region ACT in a thickness direction of the substrate SUB.

The interlayer insulating layer ILD may be disposed on the second metal layer MTL2. The interlayer insulating layer ILD may insulate the second metal layer MTL2 from the third metal layer MTL3.

The third metal layer MTL3 may be disposed on the interlayer insulating layer ILD. The third metal layer MTL3 may include a connection electrode CE, a first anode connection electrode ANE1, a horizontal voltage line HVDL, and a second voltage line VSL. The connection electrode CE may electrically connect the voltage line VL and the source electrode SE of the thin-film transistor TFT. The first anode connection electrode ANE1 may electrically connect the drain electrode DE of the thin-film transistor TFT and a first contact electrode CTE1. The horizontal voltage line HVDL may electrically connect the first voltage line VDL and a first electrode RME1. The second voltage line VSL may electrically connect the vertical voltage line VVSL and a second electrode RME2 and electrically connect the vertical voltage line VVSL and a fourth contact electrode CTE4.

The passivation layer PV may be disposed on the third metal layer MTL3. The passivation layer PV may be disposed on multiple thin-film transistors TFT to protect pixel circuits of pixels.

The via layer VIA may be disposed on the passivation layer PV. The via layer VIA may planarize a surface above the thin-film transistor layer TFTL. The via layer VIA may include an organic insulating material such as polyimide (PI).

The light emitting element layer EML may be disposed on the thin-film transistor layer TFTL. The light emitting element layer EML may include first through third bank patterns BP1 through BP3, first and second electrodes RME1 and RME2, a first insulating layer PAS1, light emitting elements ED1 and ED2, a bank layer BNL, a second insulating layer PAS2, first through fourth contact electrodes CTE1 through CTE4, and a third insulating layer PAS3.

The bank layer BNL may define an emission area EMA. The bank layer BNL may surround an area where the light emitting elements ED1 and ED2 and the electrodes RME1 and RME2 are disposed.

The first through third bank patterns BP1 through BP3 may be spaced apart from each other. The first bank pattern BP1 may be disposed between the second and third bank patterns BP2 and BP3. The second bank pattern BP2 may be disposed on a left side of the first bank pattern BP1, and the third bank pattern BP3 may be disposed on a right side of the first bank pattern BP1. Each of the first through third bank patterns BP1 through BP3 may protrude upward (DR3 direction) from the via layer VIA. Each of the first through third bank patterns BP1 through BP3 may have inclined side surfaces. Multiple light emitting elements ED1 and ED2 may be disposed between the bank patterns BP1 through BP3 spaced apart from each other. For example, a first light emitting element ED1 may be disposed between the first bank pattern BP1 and the second bank pattern BP2, and a second light emitting element ED2 may be disposed between the first bank pattern BP1 and the third bank pattern BP3.

The first electrode RME1 and the second electrodes RME2 may be disposed in a fourth metal layer MTL4. A maximum width of each second electrode RME2 in a second direction DR2 may be greater than a maximum width of the first electrode RME1 in the second direction DR2, but the disclosure is not limited thereto. The fourth metal layer MTL4 may be disposed on the via layer VIA and the first through third bank patterns BP1 through BP3.

Each of the first and second electrodes RME1 and RME2 may cover upper and inclined side surfaces of one of the first through third bank patterns BP1 through BP3. The first and second electrodes RME1 and RME2 may be reflective electrodes. The fourth metal layer MTL4 may be a single layer or a multilayer made of at least one of molybdenum (Mo), aluminium (Al), chromium (Cr), gold (Au), silver (Ag), titanium (Ti), nickel (Ni), palladium (Pd), indium (In), neodymium (Nd), and copper (Cu). The fourth metal layer MTL4 may include at least one layer including a material having high reflectivity. Therefore, each of the first and second electrodes RME1 and RME2 may reflect light, which is emitted from the first and second light emitting elements ED1 and ED2, in an upward direction.

The first electrode RME1 may be connected to the horizontal voltage line HVDL of the third metal layer MTL3 through multiple fifth through holes CNT5. The first electrode RME1 may receive a driving voltage or a high-potential voltage from the horizontal voltage line HVDL. The second electrodes RME2 may be connected to the second voltage line VSL of the third metal layer MTL3 through multiple sixth through holes CNT6. The second electrodes RME2 may receive a low-potential voltage from the second voltage line VSL.

The first insulating layer PAS1 may cover the first and second electrodes RME1 and RME2. The first insulating layer PAS1 may include an inorganic layer. The first and second light emitting elements ED1 and ED2 may be insulated from the first and second electrodes RME1 and RME2 by the first insulating layer PAS1. The light emitting elements ED1 and ED2 may be disposed on the first electrode RME1 and the second electrodes RME2.

The first through fourth contact electrodes CTE1 through CTE4 may be disposed in a fifth metal layer MTL5. The first through fourth contact electrodes CTE1 through CTE4 may be transparent electrodes. For example, the fifth metal layer MTL5 may include at least one of indium tin oxide (ITO), indium zinc oxide (IZO), and indium tin zinc oxide (ITZO). The fifth metal layer MTL5 may have, but is not limited to, a stacked structure of ITO/Ag/ITO, ITO/Ag/IZO, or ITO/Ag/ITZO/IZO.

The second insulating layer PAS2 may be disposed on the bank layer BNL, the first insulating layer PAS1, and the light emitting elements ED. The third insulating layer PAS3 may cover the second insulating layer PAS2 and the first through fourth contact electrodes CTE1 through CTE4. Each of the second and third insulating layers PAS2 and PAS3 may include an inorganic material. The second and third insulating layers PAS2 and PAS3 may insulate each of the first through fourth contact electrodes CTE1 through CTE4. Each of the second through fourth contact electrodes CTE2 through CTE4 may include an opening in a center, but the disclosure is not limited thereto.

The first contact electrode CTE1 may be disposed on a second electrode RME2 and may be connected to the first anode connection electrode ANE1 of the third metal layer MTL3 through a first through hole CNT1. The first contact electrode CTE1 may be connected between the first anode connection electrode ANE1 and ends of multiple first light emitting elements ED1. The first contact electrode CTE1 may supply a driving current to the first light emitting elements ED1. The first contact electrode CTE1 may correspond to anodes of the first light emitting elements ED1, but the disclosure is not limited thereto.

The second contact electrode CTE2 may be disposed on the first electrode RME1. The second contact electrode CTE2 may be connected to another ends of the first light emitting elements ED1. The second contact electrode CTE2 may correspond to cathodes of the first light emitting elements ED1, but the disclosure is not limited thereto.

The third contact electrode CTE3 may be disposed on the first electrode RME1. The third contact electrode CTE3 may be connected to ends of multiple second light emitting elements ED2. The third contact electrode CTE3 may correspond to anodes of the second light emitting elements ED2, but the disclosure is not limited thereto.

The fourth contact electrode CTE4 may be disposed on a second electrode RME2 and may be connected to the second voltage line VSL of the third metal layer MTL3 through a fourth through hole CNT4. The fourth contact electrode CTE4 may be connected between the second voltage line VSL and another ends of the second light emitting elements ED2. The fourth contact electrode CTE4 may correspond to cathodes of the second light emitting elements ED2, but the disclosure is not limited thereto. The fourth contact electrode CTE4 may receive a low-potential voltage through the second voltage line VSL.

In the display device 10 of FIG. 27, two electrodes RME1 and RME2 spaced apart and extending parallel to each other may disposed on the substrate SUB, and a light emitting element ED may be disposed in a direction parallel to an upper surface of the substrate SUB. However, the disclosure is not limited thereto. Depending on the structure of the display device 10, the light emitting element ED may be disposed in a direction perpendicular to the upper surface of the substrate SUB.

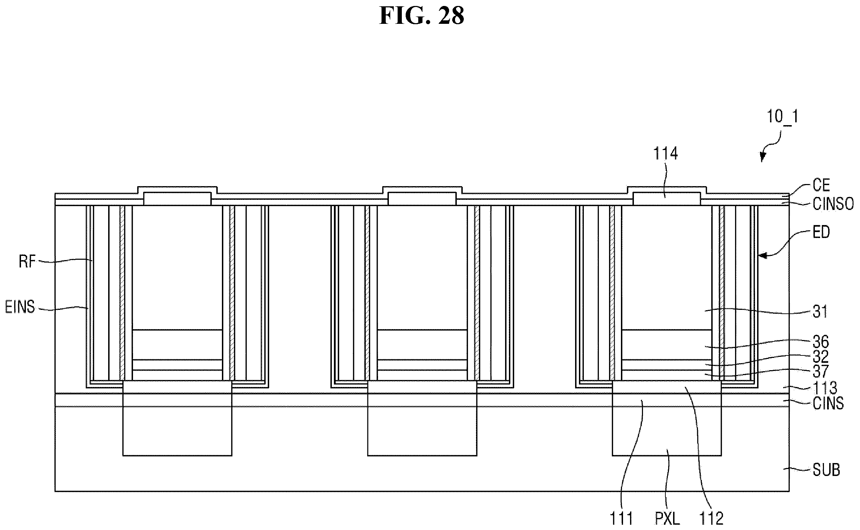

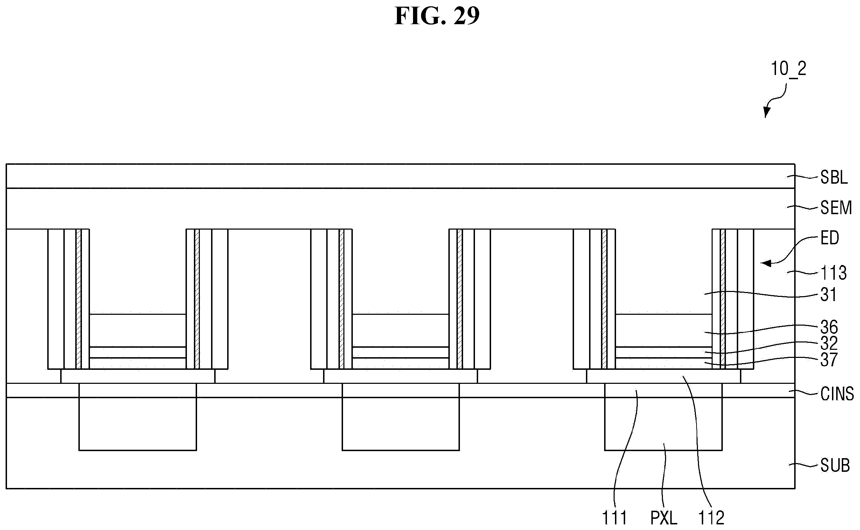

FIGS. 28 and 29 are schematic cross-sectional views of display devices according to embodiments.

Referring to FIG. 28, a display device 10_1 may include multiple light emitting elements ED spaced apart from each other on a substrate SUB. The light emitting elements ED may be disposed such that semiconductor layers 31 and 32 are stacked in a direction perpendicular to an upper surface of the substrate SUB.

The display device 10_1 may include the substrate SUB, multiple pixel circuit units PXL formed in the substrate SUB, and multiple light emitting elements ED disposed on the substrate SUB.

The substrate SUB may be a silicon wafer substrate formed using a semiconductor process. The pixel circuit units PXL of the substrate SUB may be formed using a semiconductor process.

The pixel circuit units PXL may be disposed on the entire surface of the display device 10_1. Each of the pixel circuit units PXL may be connected to a corresponding pixel electrode 111. For example, multiple pixel circuit units PXL and multiple pixel electrodes 111 may be connected to correspond one-to-one to each other. Each of the pixel circuit units PXL may overlap a light emitting element ED in a thickness direction.

Each of the pixel circuit units PXL may include at least one transistor formed by a semiconductor process. Each of the pixel circuit units PXL may further include at least one capacitor formed by a semiconductor process. Each of the pixel circuit units PXL may include, for example, a CMOS circuit. Each of the pixel circuit units PXL may apply a pixel voltage or an anode voltage to a pixel electrode 111.

A circuit insulating layer CINS may be disposed on the substrate SUB. The circuit insulating layer CINS may expose the pixel electrodes 111 so that the pixel electrodes 111 can be connected to the light emitting elements ED. The circuit insulating layer CINS may protect the pixel circuit units PXL and planarize steps formed by the pixel electrodes 111 disposed on the pixel circuit units PXL. The circuit insulating layer CINS may include an inorganic insulating material such as silicon oxide ($SiO_x$), silicon nitride ($SiN_x$), silicon oxynitride ($SiO_xN_y$), aluminium oxide ($Al_xO_y$), or aluminium nitride (AlN).

The pixel electrodes 111 may be disposed on corresponding pixel circuit units PXL. Each of the pixel electrodes 111 may be an exposed electrode exposed from a pixel circuit unit PXL. Each of the pixel electrodes 111 may be formed integrally with the pixel circuit unit PXL. Each of the pixel electrodes 111 may receive a pixel voltage or an anode voltage from the pixel circuit unit PXL. The pixel electrodes 111 may include a metal material such as aluminium (Al).

A light emitting element layer may be disposed on the substrate SUB. The light emitting element layer may include connection electrodes 112 and 114, the light emitting elements ED, and a common electrode CE. The light emitting element layer may include a reflective layer RF and a planarization layer 113.

First connection electrodes 112 may be disposed on corresponding pixel electrodes 111. The first connection electrodes 112 may include a metal material for bonding the pixel electrodes 111 and the light emitting elements ED. For example, the first connection electrodes 112 may include at least one of gold (Au), copper (Cu), aluminium (Al), and tin (Sn). In another embodiment, the first connection electrodes 112 may include a first layer including one of gold (Au), copper (Cu), aluminium (Al) and tin (Sn) and a second layer including another one of gold (Au), copper (Cu), aluminium (Al) and tin (Sn).

The light emitting elements ED may be disposed on the first connection electrodes 112. Each of the light emitting elements ED may be the light emitting element ED described above with reference to FIG. 1. The display device 10_1 may include multiple light emitting elements ED disposed to correspond to the pixel electrodes 111 and the first connection electrodes 112. The light emitting elements ED may extend in a direction and may be disposed such that the direction is perpendicular to the upper surface of the substrate SUB. In an embodiment, each of the light emitting elements ED may be disposed such that a second semiconductor layer 32 or an electrode layer 37 faces a first connection electrode 112.

The reflective layer RF and an element insulating layer EINS may be disposed on side surfaces of the light emitting elements ED.

The reflective layer RF may surround an insulating film 38 of each of the light emitting elements ED. The reflective layer RF may reflect light, which is emitted from the side surfaces of each light emitting element ED, in the upward direction. In an embodiment, the reflective layer RF may include a material having high reflectivity. For example, the reflective layer RF may have a reflectivity greater than or equal to about 90% within a visible range and may have a thickness greater than or equal to about 5 nm.

The element insulating layer EINS may be disposed on the reflective layer RF as an insulating layer for protecting the reflective layer RF. The element insulating layer EINS may be made of aluminium oxide ($Al_2O_3$), but the disclosure is not limited thereto.

The planarization layer 113 may be disposed on the circuit insulating layer CINS and may surround the light emitting elements ED. The planarization layer 113 may be a layer for planarizing a step formed by each light emitting element ED. The planarization layer 113 may be made of an organic material such as an acryl resin, an epoxy resin, a phenolic resin, a polyamide resin, or a polyimide resin.

An element insulating layer CINSO may be disposed on the planarization layer 113 and the light emitting elements ED. The element insulating layer CINSO may expose each of the light emitting elements ED so that each of the light emitting elements ED can be connected to the common electrode CE. The element insulating layer CINSO may protect the light emitting elements ED. The element insulating layer CINSO may include multiple openings overlapping the light emitting elements ED in a thickness direction of the substrate SUB, and a portion of a lower surface of a first semiconductor layer 31 of each light emitting element ED may be exposed.

The second connection electrodes 114 may be disposed on the light emitting elements ED. The second connection electrodes 114 may include a metal material for bonding the common electrode CE described below and the light emitting elements ED. For example, the second connection electrodes 114 may include at least one of gold (Au), copper (Cu), aluminium (Al), and tin (Sn). In another embodiment, the second connection electrodes 114 may include a first layer including one of gold (Au), copper (Cu), aluminium (Al) and tin (Sn) and a second layer including another one of gold (Au), copper (Cu), aluminium (Al) and tin (Sn).

The common electrode CE may be disposed on the second connection electrodes 114 and the planarization layer 113. The common electrode CE may be a common layer formed commonly in multiple pixels. The common electrode CE may be made of a transparent conductive material (TCO) that can transmit light, such as indium tin oxide (ITO) or indium zinc oxide (IZO).

Referring to FIG. 29, a display device 10_2 may include multiple light emitting elements ED disposed in a vertical direction on a substrate SUB, and first semiconductor layers 31 of the light emitting elements ED may be connected to each other. In the display device 10_2, a first semiconductor material layer 310 may not be completely etched during a process of manufacturing the light emitting elements ED, but a lower portion of the first semiconductor material layer 310 may remain. The light emitting elements ED may be connected to each other through a common semiconductor layer SEM formed as a result of the first semiconductor material layer 310 not being completely etched. The display device 10_2 may include a semiconductor base layer SBL disposed on the common semiconductor layer SEM. The semiconductor base layer SBL may be a layer disposed on an intermediate layer IML of a base substrate BS during the process of manufacturing the light emitting elements ED. The light emitting elements ED may be integrated with each other on the semiconductor base layer SBL without being individually separated and may be disposed on the substrate SUB to form the display device 10_2. The embodiment of FIG. 29 is different from the embodiment of FIG. 28 in that the light emitting elements ED are connected to each other and that a common electrode CE is omitted.

The common semiconductor layer SEM and the first semiconductor layers 31 may include substantially a same material. Different light emitting elements ED may protrude from the common semiconductor layer SEM, and an insulating film 38 may surround semiconductor layers 31 and 32 and active layers 36 protruding from the common semiconductor layer SEM. In the process of manufacturing the light emitting elements ED, since the intermediate layer IML is disposed under the semiconductor base layer SBL, the semiconductor base layer SBL may have a low defect density. As described above, the defect density of the semiconductor base layer SBL may be less than or equal to about $1.0 * 10^8/cm^2$. For example, the defect density of the semiconductor base layer SBL may be less than or equal to about $6 * 10^7/cm^2$, and the common semiconductor layer SEM that serves as common electrodes of the light emitting elements ED in the display device 10_2 may also have a low defect density. The light emitting elements ED may be connected to each other by the semiconductor base layer SBL of the base substrate BS and the common semiconductor layer SEM without being individually separated during the manufacturing process. In this state, the light emitting elements ED may be disposed on the substrate SUB, thereby forming the display device 10_2.

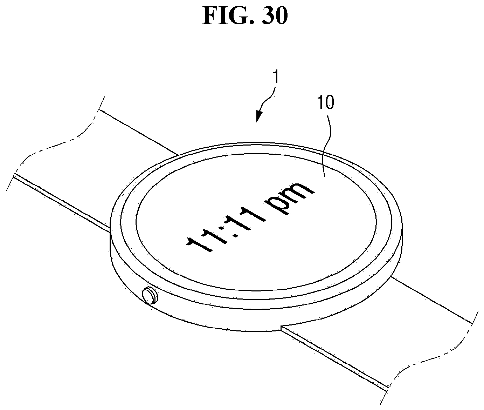

FIGS. 30 through 35 are schematic views of electronic devices including a display device according to an embodiment.

Referring to FIG. 30, a display device 10 according to an embodiment may be applied to a smart watch 1. FIG. 30 schematically illustrates an embodiment in which the smart watch 1 excluding a wristwatch strap has a circular shape in a plan view. The smart watch 1 may include a circular display device 10 and follow the planar shape of the display device 10.

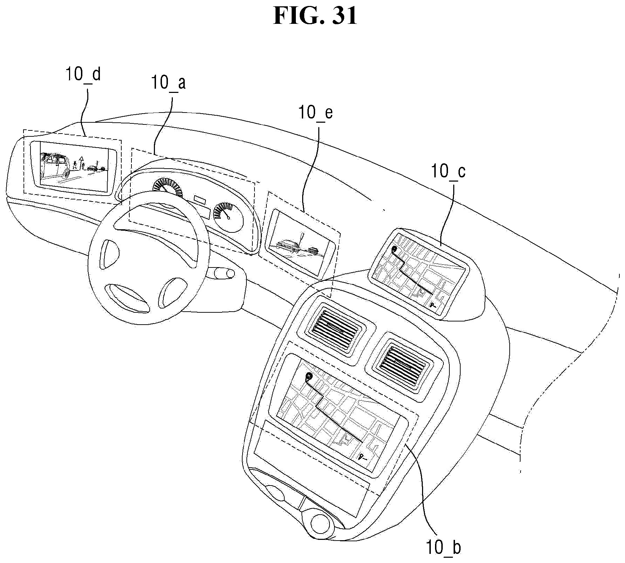

Referring to FIG. 31, display devices 10_a through 10_e according to an embodiment may be applied to an instrument cluster of a vehicle, a center fascia of the vehicle, or a center information display (CID) disposed on a dashboard of the vehicle. The display devices according to the embodiment may be applied to room mirror displays that replace side mirrors of the vehicle.

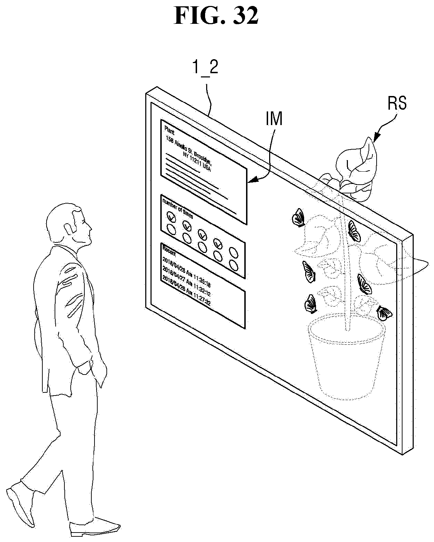

Referring to FIG. 32, a display device according to an embodiment may be applied to a transparent display device 1_2. The transparent display device 1_2 may transmit light while displaying an image IM. Therefore, a user located in front of the transparent display device 1_2 may view the image IM displayed on the display device and view an object RS or the background located behind the transparent display device 1_2. In case that the display device is applied to the transparent display device 1_2, a substrate of the display device may include a light transmitting portion that can transmit light or may be made of a material that can transmit light.

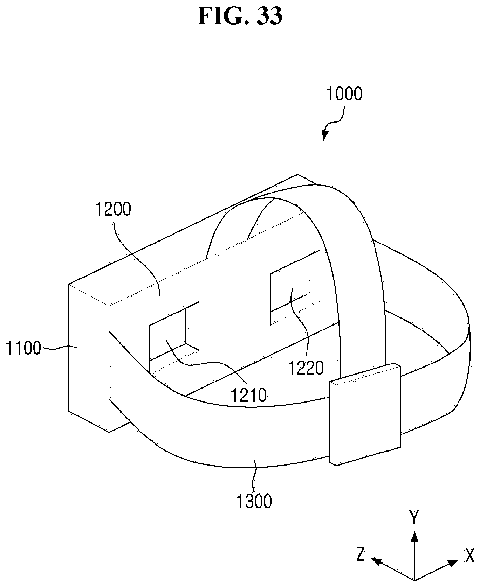

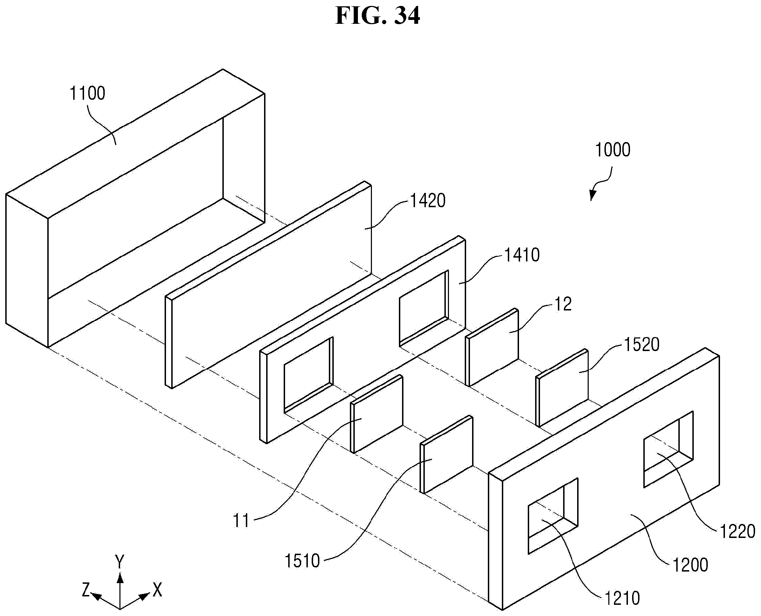

Referring to FIGS. 33 and 34, a head mounted display device 1000 according to an embodiment may include a first display device 11, a second display device 12, a display device housing 1100, a housing cover 1200, a first eyepiece 1210, a second eyepiece 1220, a head mounted band 1300, a middle frame 1410, a first optical member 1510, a second optical member 1520, a control circuit board 1420, and a connector.

The first display device 11 may provide an image to a user's left eye, and the second display device 12 may provide an image to the user's right eye. Each of the first display device 11, the second display device 12, and the display device 10 described above may be substantially the same. Therefore, a description of the first display device 11 and the second display device 12 will be omitted.

The first optical member 1510 may be disposed between the first display device 11 and the first eyepiece 1210. The second optical member 1520 may be disposed between the second display device 12 and the second eyepiece 1220. Each of the first optical member 1510 and the second optical member 1520 may include at least one convex lens.

The middle frame 1410 may be disposed between the first display device 11 and the control circuit board 1420 and may be disposed between the second display device 12 and the control circuit board 1420. The middle frame 1410 may support and fix the first display device 11, the second display device 12, and the control circuit board 1420.

The control circuit board 1420 may be disposed between the middle frame 1410 and the display device housing 1100. The control circuit board 1420 may be connected to the first display device 11 and the second display device 12 by the connector. The control circuit board 1420 may convert an image source received from the outside into digital video data and transmit the digital video data to the first display device 11 and the second display device 12 through the connector.

The control circuit board 1420 may transmit the digital video data corresponding to a left image optimized for a user's left eye to the first display device 11 and transmit the digital video data corresponding to a right image optimized for the user's right eye to the second display device 12. In another embodiment, the control circuit board 1420 may transmit a same digital video data to the first display device 11 and the second display device 12.

The display device housing 1100 may house the first display device 11, the second display device 12, the middle frame 1410, the first optical member 1510, the second optical member 1520, the control circuit board 1420, and the connector. The housing cover 1200 may cover an open surface of the display device housing 1100. The housing cover 1200 may include the first eyepiece 1210 on which a user's left eye is placed and the second eyepiece 1220 on which the user's right eye is placed. Although the first eyepiece 1210 and the second eyepiece 1220 are disposed separately in the drawings, the disclosure is not limited thereto. In another embodiment, the first eyepiece 1210 and the second eyepiece 1220 may be combined into one.

The first eyepiece 1210 may be aligned with the first display device 11 and the first optical member 1510, and the second eyepiece 1220 may be aligned with the second display device 12 and the second optical member 1520. Therefore, a user may view an image of the first display device 11, which is enlarged as a virtual image by the first optical member 1510, through the first eyepiece 1210 and may view an image of the second display device 12, which is enlarged as a virtual image by the second optical member 1520, through the second eyepiece 1220.

The head mounted band 1300 may fix the display device housing 1100 to a user's head so that the first eyepiece 1210 and the second eyepiece 1220 of the housing cover 1200 are kept placed on the user's left and right eyes, respectively. In case that the display device housing 1200 is implemented to be lightweight and small, the head mounted display device 1000 may include an eyeglass frame instead of the head mounted band 1300.

The head mounted display device 1000 may further include a battery for supplying power, an external memory slot for accommodating an external memory, and an external connection port and a wireless communication module for receiving an image source. The external connection port may be a universe serial bus (USB) terminal, a display port, or a high-definition multimedia interface (HDMI) terminal, and the wireless communication module may be a 5G communication module, a 4G communication module, a Wi-Fi module, or a Bluetooth module.

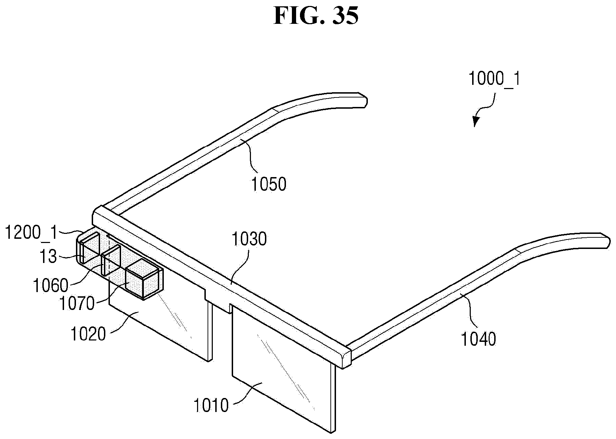

Referring to FIG. 35, a head mounted display device 1000_1 according to an embodiment may be a glasses-type display device in which a display device housing 1200_1 is implemented to be lightweight and small. The head mounted display device 1000_1 according to an embodiment may include a display device 13, a left lens 1010, a right lens 1020, a support frame 1030, eyeglass frame legs 1040 and 1050, an optical member 1060, an optical path conversion member 1070, and the display device housing 1200_1.

The display device housing 1200_1 may include the display device 13, the optical member 1060, and the optical path conversion member 1070. An image displayed on the display device 13 may be enlarged by the optical member 1060, may have its optical path converted by the optical path conversion member 1070, and may be provided to a user's right eye through the right lens 1020. Accordingly, the user may view, through the right eye, an augmented reality image into which a virtual image displayed on the display device 13 and a real image viewed through the right lens 1020 are combined.

Although the display device housing 1200_1 is disposed at a right end of the support frame 1030 in the drawing, the disclosure is not limited thereto. In another embodiment, the display device housing 1200_1 may be disposed at a left end of the support frame 1030, and an image of the display device 13 may be provided to a user's left eye. In another embodiment, the display device housing 1200_1 may be disposed at both the left and right ends of the support frame 1030, and the user may view an image displayed on the display device 13 through both the left and right eyes.

The above description is an example of technical features of the disclosure, and those skilled in the art to which the disclosure pertains will be able to make various modifications and variations. Therefore, the embodiments of the disclosure described above may be implemented separately or in combination with each other.

Therefore, the embodiments disclosed in the disclosure are not intended to limit the disclosure, but to describe the disclosure, and the scope of the disclosure is not limited by these embodiments. The protection scope of the disclosure should be interpreted by the following claims, and it should be interpreted that all embodiments within the equivalent scope are included in the scope of the disclosure.

Embodiments are set out in the following clauses.

Clause 1. A light emitting element comprising:

a first semiconductor layer doped with an n-type dopant;
a second semiconductor layer disposed on the first semiconductor layer and doped with a p-type dopant;
an active layer between the first semiconductor layer and the second semiconductor layer;
an electrode layer disposed on the second semiconductor layer; and
an insulating film surrounding an outer surface of at least the active layer, wherein
a diameter of the first semiconductor layer is in a range of about 0.5 $\mu$m to about 10 $\mu$m, and
the insulating film comprises:

a first layer surrounding the first semiconductor layer, the second semiconductor layer, and the active layer; and
a second layer disposed on the first layer and comprising aluminum nitride (AlN).

Clause 2. The light emitting element of clause 1, wherein

the diameter of the first semiconductor layer is in a range of about 0.5 $\mu$m to about 5 $\mu$m, and
the active layer emits light having a main peak wavelength in a range of about 370 nm to about 460 nm.

Clause 3. The light emitting element of clause 1 or clause 2, wherein

the insulating film further comprises a third layer disposed on the second layer and a fourth layer disposed on the third layer,
each of the third layer and the fourth layer comprises at least one of silicon oxide (SiOx), silicon nitride (SiNx), silicon oxynitride (SiOxNy), aluminum nitride (AlNx), aluminum oxide (AlOx), zirconium oxide (ZrOx), hafnium oxide (HfOx), and titanium oxide (TiOx).
x is a first rational number greater than 0, and
y is a second rational number greater than 0.

Clause 4. The light emitting element of clause 3, wherein the third layer comprises silicon oxide (SiOx) and directly contacts the second layer.

Clause 5. The light emitting element of clause 3 or clause 4, wherein

a thickness of each of the third layer and the fourth layer of the insulating film is greater than a thickness of each of the first layer and the second layer, and

the thickness of the fourth layer is greater than the thickness of the third layer.

Clause 6. The light emitting element of clause 5, wherein the thickness of each of the first layer and the second layer is in a range of about 1 nm to about 3 nm.

Clause 7. The light emitting element of clause 5 or clause 6, wherein the thickness of the third layer is greater than or equal to about 10 nm, and the thickness of the fourth layer is in a range of about 40 nm to about 100 nm.

Clause 8. The light emitting element of any one of clauses 1 to7, wherein

the first layer comprises a first sub-layer, a second sub-layer surrounding the first sub-layer, and a third sub-layer surrounding the second sub-layer,

the first sub-layer and the third sub-layer comprise a same material, and

a thickness of the first sub-layer is greater than a thickness of each of the second sub-layer and the third sub-layer.

Clause 9. The light emitting element of clause 8, wherein the first sub-layer and the third sub-layer comprise zirconium oxide ($ZrO_2$), and the second sub-layer comprises aluminum oxide ($Al_2O_3$) or hafnium oxide ($HfO_2$).

Clause 10. The light emitting element of clause 8 or clause 9, wherein

the thickness of the first sub-layer is about 2 nm, and

the thickness of each of the second sub-layer and the third sub-layer is about 1 nm.

Clause 11. The light emitting element of any one of clauses 1 to 10, wherein

a reference luminance is a luminance of light emitted in case that a first driving current is supplied,

in case that the first driving current is supplied after a second driving current is supplied, a restoration time taken for the luminance of light emitted to reach a restored luminance is less than or equal to about 10 seconds.

the restored luminance satisfies Equation 1 below,

[Equation 1]

$$0.99 \text{ x reference luminance} < \text{restored luminance} < 1.01 \text{ x reference luminance},$$

and

an intensity of the first driving current and an intensity of the second driving current are different from each other.

Clause 12. The light emitting element of clause 11, wherein the restoration time is less than or equal to about 1 second.

Clause 13. The light emitting element of clause 11 or clause 12, wherein the first driving current is in a range of about 0.5 A/cm$^2$ to about 5 A/cm$^2$.

Clause 14. The light emitting element of claim 13, wherein the second driving current is in a range of about 0 A/cm$^2$ to about 0.5 A/cm$^2$.

Clause 15. The light emitting element of claim 13, wherein the second driving current is greater than or equal to about 10 A/cm$^2$.

Clause 16. A display device comprising:

a first electrode and a second electrode spaced apart from each other on a substrate; and

a light emitting element electrically connected to each of the first electrode and the second electrode and extending in a direction, wherein

the light emitting element comprises:

a first semiconductor layer doped with an n-type dopant;

a second semiconductor layer disposed on the first semiconductor layer and doped with a p-type dopant;
an active layer between the first semiconductor layer and the second semiconductor layer;
an electrode layer disposed on the second semiconductor layer; and
an insulating film surrounding an outer surface of at least the active layer,
a diameter of the first semiconductor layer is in a range of about 0.5 $\mu$m to about 10 $\mu$m, and
the insulating film comprises:

a first layer surrounding the first semiconductor layer, the second semiconductor layer, and the active layer; and
a second layer disposed on the first layer and comprising aluminum nitride (AlN).

Clause 17. The display device of clause 16, wherein

the insulating film of the light emitting element further comprises a third layer disposed on the second layer and a fourth layer disposed on the third layer,
each of the third layer and the fourth layer comprises at least one of silicon oxide (SiOx), silicon nitride (SiNx), silicon oxynitride (SiOxNy), aluminum nitride (AlNx), aluminum oxide (AlOx), zirconium oxide (ZrOx), hafnium oxide (HfOx), and titanium oxide (TiOx).
x is a first rational number greater than 0, and
y is a second rational number greater than 0.

Clause 18. The display device of clause 16 or clause 17, wherein

a reference luminance is a luminance of light emitted in case that a first driving current is supplied,
in case that the first driving current is supplied after a second driving current is supplied, a time taken for the luminance of light emitted to reach a restored luminance is less than or equal to about 10 seconds,
the restored luminance satisfies Equation 1 below,

[Equation 1]

$$0.99 \times \text{reference luminance} < \text{restored luminance} < 1.01 \times \text{reference luminance},$$

and
an intensity of the first driving current and an intensity of the second driving current are different from each other.

Clause 19. An electronic device comprising:

a display device including a light emitting element disposed on a substrate, wherein
the light emitting element comprises:

a first semiconductor layer doped with an n-type dopant;
a second semiconductor layer disposed on the first semiconductor layer and doped with a p-type dopant;
an active layer between the first semiconductor layer and the second semiconductor layer;
an electrode layer disposed on the second semiconductor layer; and an insulating film surrounding an outer surface of at least the active layer,
a diameter of the first semiconductor layer is in a range of about 0.5 $\mu$m to about 10 $\mu$m, and
the insulating film comprises:

a first layer surrounding the first semiconductor layer, the second semiconductor layer, and the active layer; and
a second layer disposed on the first layer and comprising aluminum nitride (AlN).

Clause 20. The electronic device of clause 19, wherein the electronic device is at least one of a smart watch, a mobile phone, a smartphone, a portable computer, a tablet personal computer (PC), a watch phone, an automotive display, a smart glass, a portable multimedia player (PMP), a navigation system, an ultra mobile computer (UMPC), a head mounted display (HMD) device, a virtual reality (VR) device, a mixed reality (MR) device, and an augmented reality (AR) device.

**Claims**

1. A light emitting element comprising:

   a first semiconductor layer doped with an n-type dopant;
   a second semiconductor layer disposed on the first semiconductor layer and doped with a p-type dopant;
   an active layer between the first semiconductor layer and the second semiconductor layer;
   an electrode layer disposed on the second semiconductor layer; and
   an insulating film surrounding an outer surface of at least the active layer, wherein
   a diameter of the first semiconductor layer is in a range of about 0.5 $\mu$m to about 10 $\mu$m, and
   the insulating film comprises:

      a first layer surrounding the first semiconductor layer, the second semiconductor layer, and the active layer; and
      a second layer disposed on the first layer and comprising aluminium nitride (AlN).

2. The light emitting element of claim 1, wherein

   the diameter of the first semiconductor layer is in a range of about 0.5 $\mu$m to about 5 $\mu$m, and
   the active layer emits light having a main peak wavelength in a range of about 370 nm to about 460 nm.

3. The light emitting element of claim 1 or claim 2, wherein

   the insulating film further comprises a third layer disposed on the second layer and a fourth layer disposed on the third layer,
   each of the third layer and the fourth layer comprises at least one of silicon oxide ($SiO_x$), silicon nitride ($SiN_x$), silicon oxynitride ($SiO_xN_y$), aluminium nitride ($AlN_x$), aluminium oxide ($AlO_x$), zirconium oxide ($ZrO_x$), hafnium oxide ($HfO_x$), and titanium oxide ($TiO_x$).
   x is a first rational number greater than 0, and
   y is a second rational number greater than 0.

4. The light emitting element of claim 3, wherein the third layer comprises silicon oxide ($SiO_x$) and directly contacts the second layer.

5. The light emitting element of claim 3 or claim 4, wherein

   a thickness of each of the third layer and the fourth layer of the insulating film is greater than a thickness of each of the first layer and the second layer, and
   the thickness of the fourth layer is greater than the thickness of the third layer.

6. The light emitting element of claim 5, wherein the thickness of each of the first layer and the second layer is in a range of about 1 nm to about 3 nm.

7. The light emitting element of claim 5 or claim 6, wherein

   the thickness of the third layer is greater than or equal to about 10 nm, and
   the thickness of the fourth layer is in a range of about 40 nm to about 100 nm.

8. The light emitting element of any one of claims 1 to 7, wherein

   the first layer comprises a first sub-layer, a second sub-layer surrounding the first sub-layer, and a third sub-layer surrounding the second sub-layer,
   the first sub-layer and the third sub-layer comprise a same material, and
   a thickness of the first sub-layer is greater than a thickness of each of the second sub-layer and the third sub-layer.

9. The light emitting element of claim 8, wherein:

   (i) the first sub-layer and the third sub-layer comprise zirconium oxide ($ZrO_2$), and the second sub-layer comprises

aluminium oxide (Al$_2$O$_3$) or hafnium oxide (HfO$_3$); and/or
(ii) the thickness of the first sub-layer is about 2 nm, and

the thickness of each of the second sub-layer and the third sub-layer is about 1 nm.

10. The light emitting element of any one of claims 1 to 9, wherein

a reference luminance is a luminance of light emitted in case that a first driving current is supplied,
in case that the first driving current is supplied after a second driving current is supplied, a restoration time taken for the luminance of light emitted to reach a restored luminance is less than or equal to about 10 seconds.
the restored luminance satisfies Equation 1 below,

[Equation 1]

$$0.99 \text{ x reference luminance} < \text{restored luminance} < 1.01 \text{ x reference luminance,}$$

and
an intensity of the first driving current and an intensity of the second driving current are different from each other.

11. The light emitting element of claim 10, wherein the restoration time is less than or equal to about 1 second.

12. The light emitting element of claim 10 or claim 11, wherein the first driving current is in a range of about 0.5 A/cm$^2$ to about 5 A/cm$^2$, optionally wherein the second driving current is in a range of about 0 A/cm$^2$ to about 0.5 A/cm$^2$, or wherein the second driving current is greater than or equal to about 10 A/cm$^2$.

13. A display device comprising:

a first electrode and a second electrode spaced apart from each other on a substrate; and
a light emitting element according to claim 1, wherein the light emitting element is electrically connected to each of the first electrode and the second electrode and extending in a direction.

14. The display device of claim 13, wherein:

(i) the insulating film of the light emitting element further comprises a third layer disposed on the second layer and a fourth layer disposed on the third layer,

each of the third layer and the fourth layer comprises at least one of silicon oxide (SiO$_x$), silicon nitride (SiN$_x$), silicon oxynitride (SiO$_x$N$_y$), aluminium nitride (AlN$_x$), aluminium oxide (AlO$_x$), zirconium oxide (ZrO$_x$), hafnium oxide (HfO$_x$), and titanium oxide (TiO$_x$).
x is a first rational number greater than 0, and
y is a second rational number greater than 0, and/or

(ii) a reference luminance is a luminance of light emitted in case that a first driving current is supplied,

in case that the first driving current is supplied after a second driving current is supplied, a time taken for the luminance of light emitted to reach a restored luminance is less than or equal to about 10 seconds,
the restored luminance satisfies Equation 1 below,

[Equation 1]

$$0.99 \text{ x reference luminance} < \text{restored luminance} < 1.01 \text{ x reference luminance,}$$

and
an intensity of the first driving current and an intensity of the second driving current are different from each other.

**15.** An electronic device comprising a display device including a light emitting element according to claim 1, the light emitting element disposed on a substrate, optionally wherein the electronic device is at least one of a smart watch, a mobile phone, a smartphone, a portable computer, a tablet personal computer (PC), a watch phone, an automotive display, a smart glass, a portable multimedia player (PMP), a navigation system, an ultra mobile computer (UMPC), a head mounted display (HMD) device, a virtual reality (VR) device, a mixed reality (MR) device, and an augmented reality (AR) device.

# FIG. 1

# FIG. 2

# FIG. 3

$t_2$

REFERENCE
LUMINANCE
$(t_0)$

APPLY WHITE
STRESS
$(t_1)$

AFTER WHITE
STRESS IS
OFF
T=0s

RESTORED
LUMINANCE
$(t_R)$

# FIG. 4

48G 1.6A/cm$^2$
10min

Black stress

0G Black 0 A/cm$^2$, 20s

# FIG. 5

# FIG. 6

# FIG. 7

255G White 50.1 A/cm$^2$, 20s

48G 1.6A/cm$^2$
10min

White Stress

# FIG. 8

**FIG. 9**

# FIG. 10

# FIG. 11

# FIG. 12

PREPARE BASE SUBSTRATE AND FORM FIRST SEMICONDUCTOR MATERIAL LAYER ON BASE SUBSTRATE — S10

FORM SEMICONDUCTOR LAMINATE BY FORMING ACTIVE MATERIAL LAYER, SECOND SEMICONDUCTOR MATERIAL LAYER, AND ELECTRODE MATERIAL LAYER ON FIRST SEMICONDUCTOR MATERIAL LAYER — S20

FORM SEMICONDUCTOR ROD BY ETCHING SEMICONDUCTOR LAMINATE IN DIRECTION PERPENDICULAR TO UPPER SURFACE OF BASE SUBSTRATE AND FORM INSULATING FILM ON SEMICONDUCTOR ROD — S30

FORM LIGHT EMITTING ELEMENT BY SEPARATING SEMICONDUCTOR ROD ON WHICH INSULATING FILM IS FORMED FROM BASE SUBSTRATE — S40

# FIG. 13

SBL
IML
BFL     } BS
LS

# FIG. 14

310

SBL
IML
BFL  } BS
LS

**FIG. 15**

# FIG. 16

370
320
360

310

SBL
IML
BFL
LS

BS

# FIG. 17

1630
1620
1610
370
320
360

310

SBL
IML
BFL
LS

BS

1600: 1610, 1620, 1630

# FIG. 18

1st etching

1600: 1610, 1620, 1630

# FIG. 19

2<sup>nd</sup> etching

1630
1620
1610
370
320
360

310

SBL
IML  } BS
BFL
LS

1600: 1610, 1620, 1630

# FIG. 20

3rd etching

1630
1620
1610
37
32
36

31

SBL
IML
BFL
LS

BS

1600: 1610, 1620, 1630

# FIG. 21

# FIG. 22

SOL

37
32
36

300

31

SBL
IML
BFL
LS

BS

# FIG. 23

SOL

37
32
36

300

31

380

SBL
IML
BFL
LS

BS

# FIG. 24

# FIG. 25

# FIG. 26

# FIG. 27

EMA

RME2 CTE1 CTE2 RME1 CTE3 CTE4 RME2

PAS2    PAS2

BNL

PAS3
PAS2    } EML
PAS1

CNT1
CNE
BP2   ED1   BP1   ED2   BP3   CNT6   CNT4
VIA

ANE1
PV
ILD   } TFTL
CNT5
GI
BF
SUB

DE  GE  VL          VDL  HVDL          VSL      VVSL
ACT  SE
TFT

DR3
DR2

10

MTL1: VL, VDL, VVSL
ACTL: DE, ACT, SE
MTL2: GE
MTL3: CE, ANE1, HVDL, VSL
MTL4: RME1, RME2
MTL5: CTE1, CTE2, CTE3, CTE4
ED: ED1, ED2

EP 4 669 063 A1

# FIG. 28

EP 4 669 063 A1

**FIG. 29**

EP 4 669 063 A1

# FIG. 30

# FIG. 31

# FIG. 32

# FIG. 33

## FIG. 34

EP 4 669 063 A1

## FIG. 35

Europäisches
Patentamt

European
Patent Office

Office européen
des brevets

# EUROPEAN SEARCH REPORT

**Application Number**

EP 25 18 2984

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KR 2023 0107113 A (SAMSUNG DISPLAY CO LTD [KR]) 14 July 2023 (2023-07-14) * paragraphs [0150] - [0155]; figure 10 * ----- | 1,2, 10-15 | INV. H10H20/81 H10H20/84 |
| X | US 2023/066350 A1 (SIM YOUNG CHUL [KR] ET AL) 2 March 2023 (2023-03-02) | 1-7, 10-15 | |
| A | * paragraphs [0130] - [0133]; figure 7 * ----- | 8,9 | |
| X | US 2022/158039 A1 (SIM JUN BO [KR] ET AL) 19 May 2022 (2022-05-19) * paragraphs [0133] - [0152]; figures 14A-14B * ----- | 1,2, 10-15 | |
| X | US 2023/018385 A1 (CHA HYUNG RAE [KR] ET AL) 19 January 2023 (2023-01-19) * paragraphs [0054] - [0088]; figure 1 * ----- | 1,2, 10-15 | |

| | **TECHNICAL FIELDS SEARCHED (IPC)** |
|---|---|
| | H10H |

The present search report has been drawn up for all claims

| Place of search | Date of completion of the search | Examiner |
|---|---|---|
| The Hague | 11 November 2025 | Dehestru, Bastien |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 25 18 2984

This annex lists the patent family members relating to the patent documents cited in the above-mentioned European search report.
The members are as contained in the European Patent Office EDP file on
The European Patent Office is in no way liable for these particulars which are merely given for the purpose of information.

11-11-2025

| Patent document cited in search report | Publication date | Patent family member(s) | | Publication date |
|---|---|---|---|---|
| KR 20230107113 A | 14-07-2023 | CN | 118922950 A | 08-11-2024 |
| | | EP | 4462490 A1 | 13-11-2024 |
| | | KR | 20230107113 A | 14-07-2023 |
| US 2023066350 A1 | 02-03-2023 | CN | 116072789 A | 05-05-2023 |
| | | KR | 20230033773 A | 09-03-2023 |
| | | TW | 202320358 A | 16-05-2023 |
| | | US | 2023066350 A1 | 02-03-2023 |
| | | WO | 2023033427 A1 | 09-03-2023 |
| US 2022158039 A1 | 19-05-2022 | CN | 114551677 A | 27-05-2022 |
| | | KR | 20220069185 A | 27-05-2022 |
| | | KR | 20250065557 A | 13-05-2025 |
| | | US | 2022158039 A1 | 19-05-2022 |
| | | US | 2024266475 A1 | 08-08-2024 |
| US 2023018385 A1 | 19-01-2023 | CN | 117730424 A | 19-03-2024 |
| | | KR | 20230013705 A | 27-01-2023 |
| | | US | 2023018385 A1 | 19-01-2023 |
| | | WO | 2023003311 A1 | 26-01-2023 |

EPO FORM P0459

For more details about this annex : see Official Journal of the European Patent Office, No. 12/82